# EUROPEAN PATENT APPLICATION

(11) **EP 1 437 703 A1**
(43) Date of publication of application: **14.07.2004**
(21) Application number: 02765453.2
(22) Date of filing: 09.09.2002
(51) Int. Cl.: G09F 9/40, G09F 9/30, G09F 9/00, G02F 1/1345, H05B 33/12, H05B 33/14, H01J 11/02

(54) **DISPLAY APPARATUS AND ITS MANUFACTURING METHOD**

(30) Priority: 07.09.2001 JP 2001271305
(71) Applicant: MATSUSHITA ELECTRIC INDUSTRIAL CO., LTD., Kadoma-shi, Osaka 571-8501 (JP)
(72) Inventor: TSUKAMOTO, Masahide, Nara-shi, Nara 631-0051 (JP); BESSHO, Yoshihiro, Yahata-shi, Kyoto 614-8295 (JP); UKAI, Takeo, Kashiba-shi, Nara 639-0252 (JP)
(74) Representative: Grünecker, Kinkeldey, Stockmair & Schwanhäusser Anwaltssozietät
(86) International application number: PCT/JP2002/009156
(87) International publication number: WO 2003/023745

(57) **Abstract**

An obj ect of the present invention is to provide a display apparatus that has, even when it is a large-sized one, a high manufacturing yield, as well as a simple structure as a whole including wirings.

In order to achieve the object, the display apparatus comprises a display unit that has, on a surface of a substrate, display elements that each include a light display member and a display unit terminal and are disposed in an array; module substrates each disposed in a different one of the areas into which a surface of the display unit on which the display unit terminals are disposed is divided; and a main wiring substrate disposed so as to cover the module substrates, wherein a first wiring for transferring electricity and signals to the module substrates is provided on the main wiring substrate, and (i) drive elements that supply drive signals, (ii) the second wiring for transferring the electricity and the signals transferred via the first wiring to the drive elements, and (iii) module output terminals for transferring the drive signals from the drive elements to the display unit terminals are provided on the module substrates.

## Description

### Technical Field

The present invention relates to display apparatuses for displaying characters and images, particularly to large-sized active matrix type display apparatuses.

### Background Art

In recent years, electronics of every sort are provided with display apparatuses.

As for display apparatuses, developments are notable in, besides CRTs that have conventionally been known, Flat Panel Displays (FPDs) such as Plasma Display Panels (hereafter, referred to as PDPs), Liquid Crystal Displays, Organic Electroluminescence Displays in which organic electroluminescence films (hereafter, referred to as organic EL films) are used, and the markets for these products have expanded recently.

Generally speaking, in an FPD, display elements (electrooptical elements) are arranged in a matrix throughout a whole transparent substrate, and drive elements that apply drive voltages to the display elements are connected thereto.

Such FPDs are used as various display apparatuses ranging from a small digital display apparatus to a large-sized image display apparatus. Particularly, active matrix type organic EL display apparatuses are expected to be useful as flat displays and flexible displays.

As for flat displays, there are high demands for ones having high definition and being large-sized. PDPs have been developed to be as large as 40 to 60 inches. Liquid crystal displays have been developed to be as large as 40 inches. Organic EL display apparatuses also have been developed to be large-sized.

As for liquid crystal display apparatuses and organic El display apparatuses, the active matrix type ones are expected to be useful.

In an active matrix type display apparatus, on the opposing surfaces of a pair of substrates, a plurality of display elements and a plurality of drive elements are formed in a matrix, respectively. Also, wirings are provided in row and column directions so as to extend from one drive element to another. According to the method popularly used, drive signals are applied to the ends of these wirings.

In this method, however, it is required that a large number of wirings, which extend from the outside of the display to the driving circuit, are formed on the opposing surfaces of the pair of substrates; therefore, the electrode resistance from the supply source of electricity and signals to the driving circuit is large. Thus, the voltage supplied from the supply source needs to be high.

Also, manufacturing a display apparatus that is large-sized and has high definition brings about a problem in terms of costs because of lowered productivity and lowered yield due to an increase in the number of pixels.

Further, there is another problem that the wirings and the positioning of parts tend to be complicated when the portion on which the driving circuit is provided is large-sized.

In view of these problems, there have been attempts to manufacture a display apparatus having a large screen by pasting together, like tiles, a plurality of display apparatuses that are each unitized in a predetermined size.

When the unitized display apparatuses are pasted together, since the positioning has to be very precise, there are problems related to the degree of difficulty for this work and the yield. In addition, there is another problem in terms of image quality that the periodicity in the arrangement of the pixels are lost at the borders between the unitized apparatuses, and these borders become conspicuous when images are displayed. The higher definition the display apparatus has, the more conspicuous the degradation of the image quality at the borders is.

In order to realize a large-sized organic thin-film EL display apparatus, there has been an idea for a direct-view display apparatus with an arrangement wherein (i) on a transparent substrate, an organic EL film and then a plurality of display elements are disposed, (ii) a plurality of driving circuit substrates are disposed in an arrangement like tiles, so as to be directly in contact with the organic EL film, and (iii) the periphery areas of the driving circuit substrates are sealed together with a sealing member. On the driving circuit substrates, driving circuits are provided in correspondence with the display elements, in order to supply signals to the signal electrode and the scanning electrode of each display element.

In a case of such a display apparatus, there is no need to position the unitized display apparatuses very precisely and it is possible tomaintain the periodicity in the arrangement of the pixels as a whole screen; therefore, it is possible to display in a large-sized screen in which the borders are not conspicuous, as well as to achieve simplification of the manufacturing process and reduction in manufacturing costs (the Japanese Unexamined Patent Application Publication No. 2001-296814).

Further, as one of the techniques to realize a large-sized liquid crystal display, it is disclosed that a liquid crystal display portion is manufactured as one large part without being unitized, whereas the portion on which the driving circuit is to be provided is manufactured in relatively smaller units, so that these units are disposed on a substrate with the display element portion (the Japanese Unexamined Patent Application Publication No. 2001-305999).

It is considered that, by unitizing the driving circuit portion as above, the complexity caused by the driving circuit portion being large-sized can be alleviated to an extent.

As for large-sized display apparatuses, also, there has been a demand that each apparatus, as a whole, is thin and also has a simple structure; however, the conventional technique is not sufficient to meet this demand necessarily.

More specifically, in the display apparatuses disclosed in those two application publications above, it is also required that the driving circuit substrates are electrically connected with each other, in order to have an image displayed by all the display elements together; however, the disclosures do not include information on how to make the wirings simple in the whole display apparatus.

In this regard, the latter application publication mentions that, in order to make electric connection, a plurality of wiring substrates are provided between the substrate with display elements and unitized substrates on which the driving circuits are provided; however, it is still expected that the wiring structure is complicated.

Also, for the display apparatuses disclosed in these application publications, it is also imaginable, for example, that various types of wirings are drawn out of the driving circuit substrates in order to connect them electrically; however, even if that is the case, it is expected that the drawn wirings are complicated.

### Disclosure of the Invention

It is an object of the present invention to provide a display apparatus that, even when it is large-sized, has a high manufacturing yield and whose structure as a whole, including the wirings, is simple.

In order to achieve the object, the present invention provides a display apparatus comprising: a display unit including (i) a substrate and (ii) display elements that are disposed on a surface of the substrate so as to be arranged in an array and each of which includes a light display member and a display unit terminal; a plurality of module substrates each of which is disposed over a plurality of the display elements; a main wiring substrate disposed so as to cover the module substrates, wherein a first wiring for transferring electricity and signals to the module substrates is provided on the main wiring substrate, and (i) a drive element that supplies a drive signal, (ii) a second wiring for transferring the electricity and the signals transferred via the first wiring to the drive element, and (iii) a module output terminal for transferring the drive signal outputted from the drive element to the display unit terminals are provided on each of the module substrates.

Here, the "light display member" has a function of adjusting the quantity of light emission in accordance with the electric signals inputted via the display unit terminals, and is, for example, "an EL light emitting element which includes an organic EL film", "a liquid crystal display element which includes a liquid crystal layer", or "a light emitting cell in a PDP".

According to the display apparatus with the arrangement above, electricity and signals are transferred to the drive elements via the first wiring provided on the main wiring substrate and the second wiring provided on the module substrate; therefore, there is no need to provide wirings for such purposes in the display unit, and also there is no need to draw wirings from the module substrates. Thus, it is possible to make the structure of the display unit simple, and also make the structure of the whole display apparatus simple.

In addition, since the main wiring substrate is provided being separate from the display unit and the module substrate, it is possible to have sufficient space for providing the first wiring on the surface of the main wiring substrate. Thus, it is possible to keep the wiring resistance low, from the supply source of electricity and signals to the drive elements, even if the display apparatus is large-sized.

Further, since the display unit terminals are connected with the module output terminals, it is possible to have electric connection between the drive elements and the display elements.

Here, by positioning the module output terminals on the module substrates so that they oppose the display unit terminals in the display unit, it is easy to make connection between the display unit terminals and the module output terminals.

Additionally, by providing a substrate output terminal being connected to the first wiring on such a surface of the main wiring substrate that opposes the module substrates and providing a module input terminal being connected to the second wiring so that it is positioned in correspondence with the position of the substrate output terminal, it is possible to easily make electric connection between the first wiring and the second wiring.

As for electric connection to the display unit, by providing, on the main wiring substrate, a wiring-for-display-unit to make electric connection to the display unit and providing a terminal to be connected with the display unit either on the edge of one module substrate or in the gap between two module substrates, it is possible to make electric connection and supply electricity to the central area of the display unit, with a simple structure. Especially, in a large-sized display apparatus, it is advantageous to be able to supply electricity directly to the central area of the display unit.

The display apparatus with the aforementioned arrangement also has advantageous manufacturing features as follows:

It is easy to manufacture the display apparatus since after manufacturing each of the display unit, the module substrate, and the main wiring substrate, individually, they are pasted together in order to obtain a display apparatus. Also, it is possible to manufacture display apparatuses with a high yield because after manufacturing the display units, the module substrates, and the main wiring substrates, individually, only good ones among those will be used.

For example, it is possible to manufacture the display apparatus by (i) pasting a plurality of module substrates onto areas of the display unit while electrically connecting the display unit terminals with the module output terminals, and (ii) pasting the main wiring substrate so as to cover the module substrates while making electric connection therebetween.

When the module substrates are pasted onto the display unit, it is easy to provide electric connection by positioning the display unit terminals and the module output terminals so that they oppose each other.

Further, even if defects are found in some module substrates after the module substrates have been pasted, it is sufficient to replace only the module substrates with defects with good products. Thus, it is possible to manufacture large-sized display apparatuses with a high yield.

Manufacturing the display unit does not require a technique of pasting pieces together like tiles. In this regard also, it is possible to manufacture the display unit easily.

When the main wiring substrate is manufactured, the first wiring can be made all at once with the use of a technique for printed wiring substrates; therefore, the manufacturing is easy.

In the display apparatus above, it is also acceptable to insert at least one relay substrate between the display unit and the module substrates and to provide, on the relay substrate, via holes for electrically connecting the display unit terminals with the module output terminals. The "via holes" mentioned here also include "through holes".

In such a case, by using various relay substrates, it is possible to manufacture display apparatuses in which the display units each have different screen sizes or different image definition levels, with the use of only one kind of modules substrates. Thus, it is possible to manufacture various types of display apparatus efficiently.

Further, when the relay substrate is used, even if the pitch with which the module output terminals are arranged in an array is smaller than the pitch with which the display unit terminals are arranged in an array, it is possible to electrically connect the display unit terminals with the module output terminals while compensating the positional discrepancies, due to the pitch difference, between the display unit terminals and the module output terminals, with the use of the via holes.

Here, when the pitch with which the module output terminals are arranged is smaller, it is possible to make the area of a module substrate smaller than an area occupied by a predetermined pieces of display elements that are driven by the drive element on that module substrate, and thus it is possible to provide gaps between the module substrates; therefore, it is also possible to provide a path for supplying electricity to the display unit or a path for supplying signals and electricity from the main wiring substrate to the module substrates in these gaps.

When the relay substrate is provided in the display apparatus as mentioned above, by disposing, side by side, the plurality of module substrates on the relay substrate, it is possible to manufacture the display apparatus by (i) at first, pasting the plurality of module substrates onto the relay substrate, and then (ii) pasting the resulting joined member onto the display unit. This way, it is easy to paste the module substrates onto the display unit. Also, by checking whether each joined member is a good product or not, and pasting only good joined members onto display units, it is possible to manufacture display apparatuses having high reliability with a high yield.

Particularly, when an organic EL film is used in the display unit, and a finished display apparatus has some defects, it is difficult to repair the display apparatus; therefore, manufacturing with a high yield has a large advantageous effect.

It is also acceptable if the display apparatus has the following arrangements:

The drive element is embedded in such a surface of the module substrate on which the module output terminal is disposed, and the wiring that connects the drive element with the module output terminal is also provided on the same surface. With this arrangement, the manufacturing is easy and is also at a low cost.

It is also acceptable that each module substrate has a multi-layer wiring structure and the drive element is embedded into the inside of the substrate. By embedding the drive element into the inside of the substrate, it is possible to make the surface of each module substrate flatter. Thus, it is possible to easily and securely connect the module substrates with the display unit, the main wiring substrate, ortherelaysubstrate.

By using a mixture which includes a thermosetting resin and contains an organic filler within a range of 70 to 95 weight% as the base material of the module substrates and the relay substrate, it is not only easy to make the thermal expansion coefficients of these substrates closer to the thermal expansion coefficient of the insulative transparent substrate, but also possible to make the heat conductivity of the substrates higher so as to improve the level of heat releasing. Accordingly, even if heat generation at the display unit is at a high level, it is possible to inhibit warping of the display apparatus and maintain the reliability of the display apparatus.

Whenmonocrystal IC silicon is used for the drive elements on the module substrates, it is possible to allow the drive elements to have built-in functions of processing signals and memory. Particularly, when LSI is used, it is possible to have the drive elements serve to manage many of the circuit functions required in the display apparatus.

Alternatively, it is acceptable to use a silicon transistor circuit formed with a thin film as the drive element. When it is formed with a thin film, the size of the drive element tends to be large compared to the monocrystal silicon IC; however, it is easier to draw wirings from it and also it is at a low cost.

When an electrically conductive adhesive is used to make the connection between the display unit terminals in the display unit, the module output terminals on the module substrates, and the electrode terminals on the main wiring substrate and on the relay substrate, it is possible to make electric connection between a large number of electrode terminals all at once, without having to apply high heat or pressure. Accordingly, since it is possible to prevent the display units from being damaged by the heat or pressure during the manufacturing process, it is possible to manufacture the products with high reliability. Particularly, when a material with low heat-resistance such as an organic EL film is used in the display unit, this arrangement is effective.

Further, when an elastic member having electric conductivity is interposed to allow electric connection between those substrates having relatively large gaps between each other, for example (i) between the terminals on the relay substrate and the terminals on the main wiring substrate, (ii) between the main wiring substrate and the display unit, it is easy to make electric connection, and also the connection is secure.

By having an arrangement wherein the main wiring substrate has substantially the same shape as the insulative transparent substrate, it is possible to seal the display elements in by just sealing the peripheral area sandwiched between the main wiring substrate and the insulative transparent substrate. Thus, it is possible to obtain a display apparatus with high reliability. Especially, when an organic EL film is used for the display elements, and the display elements are sealed in as above, it is possible to prevent the organic EL film from being degraded by the air outside. Thus, the effect of improving the reliability is large.

### Brief Description Of The Drawings

FIG. 1 is a schematic cross-sectional view of the display apparatus 1 of the first embodiment;
FIG. 2 is a schematic plan view of the display apparatus 1;
FIGs. 3A and 3B are a plan view and a side view of the display unit 10 of the display apparatus 1, respectively;
FIGs. 4A and 4B are an upper-face view and a side view of the module substrate 20, respectively;
FIG. 5 is a plan view of the main wiring substrate 30, being viewed from the upper-surface side;
FIG. 6 shows the arrangement of the drive elements 21 and how the wirings are provided therebetween in the display apparatus 1;
FIG. 7 shows the circuit structure of an IC chip that could serve as one of the drive elements 21;
FIG. 8 shows the timing at which an external driving device supplies various kinds of signals to the drive elements;
FIG. 9 is a schematic cross-sectional view of the display apparatus 2 of the second embodiment;
FIG. 10 is a schematic view of the module substrate 40 in the display apparatus 2;
FIG. 11 is a schematic cross-sectional view of the display apparatus 3 of the third embodiment;
FIG. 12 is a plan view of the relay substrate 50, being viewed from the rear surface side;
FIG. 13 shows the joined sheet member in which a plurality of module substrates 20A are pasted onto the relay substrate 50;
FIG. 14 is a schematic cross-sectional view of the display apparatus 4 of the fourth embodiment;
FIG. 15 is a schematic cross-sectional view of the display apparatus 5 of the fifth embodiment; and
FIG. 16 is a schematic cross-sectional view of the display apparatus 6 of the sixth embodiment.

### Best Mode for Carrying Out the Invention

The following describes in detail the embodiments of the present invention with reference to the drawings.

### First Embodiment

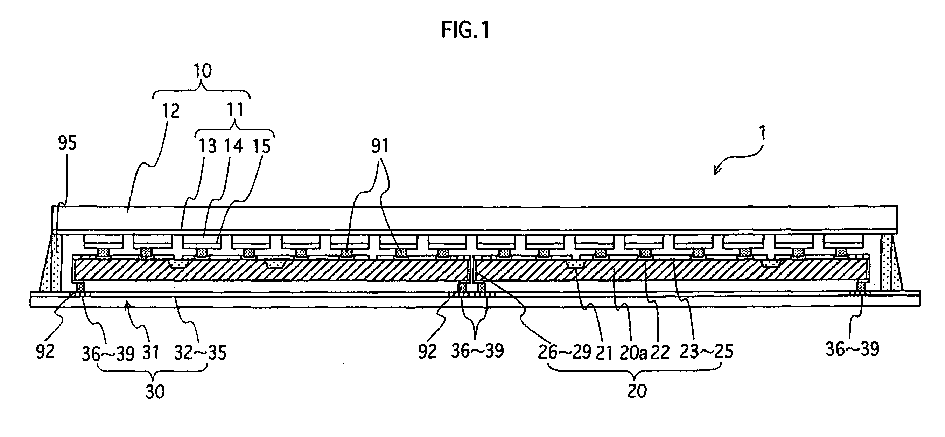

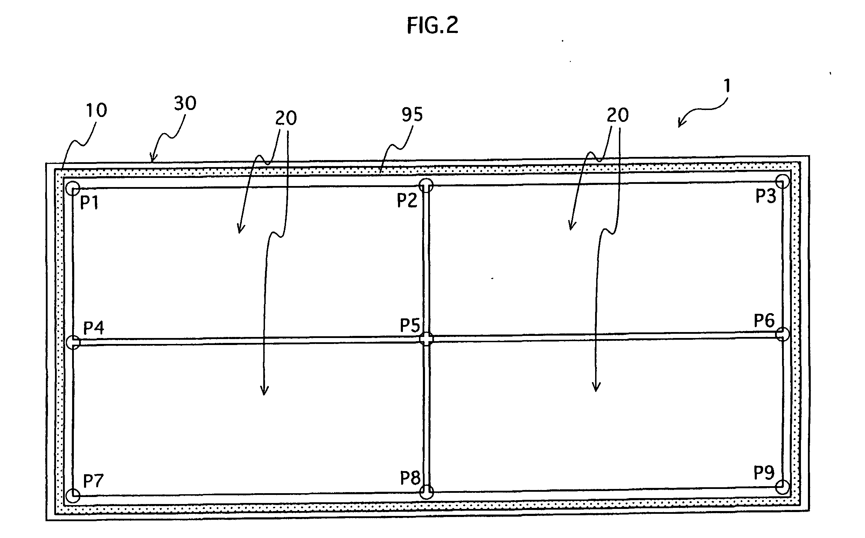

FIG. 1 is a schematic cross-sectional view of the display apparatus 1 of the first embodiment, and FIG. 2 is a plan view thereof. The display apparatus 1 is an organic EL display apparatus in which light display elements formed with organic EL films are provided.

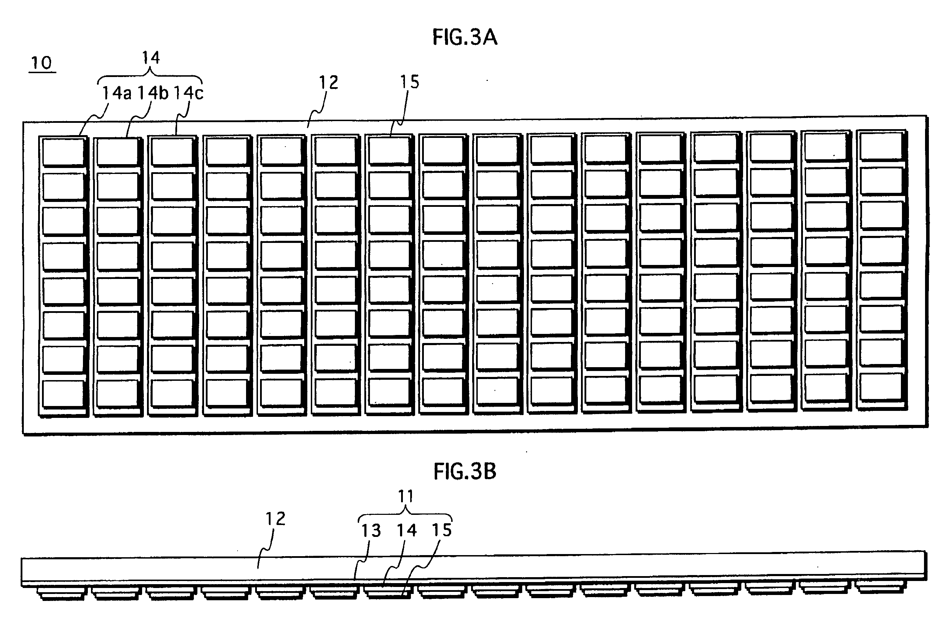

The display apparatus 1 comprises a display unit 10 including display elements being disposed in a matrix; a plurality of module substrates 20 being disposed side by side on the rear surface of the display unit 10; and a main wiring substrate 30 being provided so as to cover the plurality of module substrates 20. Here, for the sake of convenience in the explanation, the top and the bottom in FIG. 1 will be referred to as the "upper surface direction" and the "rear surface direction", respectively. In FIGs. 2 and 3A, the direction up and down will be referred to as "the column direction" and the direction across will be referred to as "the row direction".

As shown in FIGs. 1 and 2, the rear surface of the display unit 10 is divided into a plurality of areas (In these figures, it is divided into four areas, which are two by two in the column and row directions). The module substrates 20 are pasted side by side onto the divided areas. In addition, the main wiring substrate 30 is provided so as to cover all of the module substrates 20.

The display apparatus 1 receives electricity and various signals such as image signals from an external driving device and displays images according to the supplied image signals.

In the example shown in FIGs. 1 to 3, the display elements 11 are disposed in an arrangement of 8 (in the column direction) by 16 (in the row direction), and four module substrates are pasted. Hereafter, explanation will be provided according to this example. It should be noted, however, that the number of the display elements 11 provided in the display apparatus 1 is normally determined based on the level of definition of image display required. For example, in order to display an image with a high definition level, it is necessary to provide millions of display elements, and the number of module substrates to be provided in the display apparatus 1 will be also hundreds of thousand.

### Structure of the Display Unit 10

As shown in FIGs. 3A and 3B, in the display unit 10, a transparent conductive film 13 is provided in a solid pattern on the entire rear surface of the transparent insulative substrate 12. The organic EL films 14 are provided in stripes on the transparent conductive film 13. The display unit terminals 15 are disposed on the organic EL films 14.

With this arrangement, on the rear surface of the transparent insulative substrate 12, the display elements 11, which are each made up of, at least, a part of the transparent conductive film 13 and a display unit terminal 15 that are disposed so as to oppose each other with an organic EL film 14 interposed therebetween, are disposed in a matrix. A display unit terminal 15 is exposed on the rear-direction side of each display element 11.

For the transparent insulative substrate 12, it is acceptable to use a plastic substrate having transparency, instead of a glass substrate, which is popularly used. By using a plastic substrate, it is possible to make the display unit 10 flexible.

The transparent conductive film 13 is a thin film being made of transparent conductive material (e. g. ITO).

The organic EL film 14 includes a light emitting layer being made of an organic light emitting material, as well as, for example, a conductive polymer layer being laminated.

The display unit terminals 15 are thin films being made up of a metal material that has high electric conductivity. As for this metal material, aluminum doped with Ca or Li can be used, for example. Alternatively, laminates of gold, silver, or copper can be used, for example.

In the display unit 10 with the aforementioned structure, when a predetermined drive voltage is applied to between a transparent conductive film 13 and a display unit terminal 15, electric current runs through the organic EL film 14, and light is emitted.

As shown in FIG. 3, as for the organic EL films 14, a red light (R-light) emitting organic EL film 14a, a green light (G-light) emitting organic EL film 14b, and a blue light (B-light) emitting organic EL film 14c are disposed in turns so that each display element 11 emits one of R-light, G-light, and B-light. Display elements 11 that are positioned adjacent to one another and are for three different colors form one pixel.

### Structure of the Module Substrate 20

Basically, the module substrate 20 is something like a COF (Chip on Film) or TAB (Tape Automated Bonding).

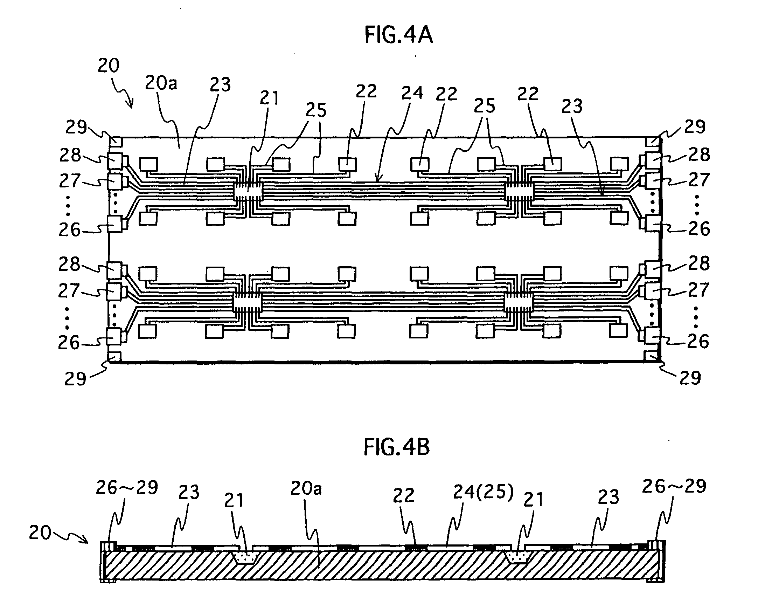

FIGs. 4A and 4B show an example of the module substrate 20. FIG. 4A is an upper-face view. FIG. 4B is a cross sectional view, being sectioned along the row direction.

The module substrate 20 includes a rectangular sheet-like base member 20a, (i) in a surface portion thereof, a plurality of drive elements 21 are embedded; (ii) on the upper surface thereof, the module output terminals 22 and the wirings in different patterns, 23, 24 and 25 are provided; and (iii) on the edges thereof, the module input terminals 26 to 28 are provided.

When the display apparatus has been assembled together, the module output terminals 22 are electrically connected with their respectively corresponding display unit terminals 15 in the display unit 10 so as to transmit signals from the drive element 21. The module output terminals 22 are, like the display unit terminals 15, disposed in a matrix, on the upper surface of the sheet-like base member 20a. In this case, four drive elements 21 (two by two in the column and row directions) are disposed on one module substrate 20. Each of the drive elements 21 controls the lighting of eight display elements 11 via eight module output terminals 22 (four in each of the two rows).

Each of the drive elements 21 has a circuit for (i) receiving, for each frame, an image signal (indicating the level of luminance for each of the eight display elements) transmitted via the main wiring substrate 30, and (ii) controlling the driving current in correspondence with the luminance level for each of the eight display elements. Specifically, it would be suitable to use a drive-purpose silicon IC (including an output pad for supplying driving current to the display elements and an input pad for taking in image signals, electric supply and so on), which is commercially available.

In the example shown in FIGs. 4A and 4B, the drive elements 21 are each a trapezoidal IC chip and embedded in the sheet-like base member 20a. The upper surface of the IC chip is substantially flush with the surface of the sheet-like base member 20a, so that the whole surface of the module substrate 20 is substantially flat.

It should be noted, however, that the drive elements 21 do not necessarily have to be embedded in the sheet-like base member 20a, and it is acceptable if the drive elements 21 are mounted on the surface of the sheet-like base member 20a.

The module input terminals 26 are for the module driving power source (the power source for driving the drive elements 21). The module input terminals 27 are for image signals. The module input terminals 28 are for chip select signals (which control the timing at which each drive element 21 receives an image signal). Although FIG. 4A shows only these three kinds of module input terminals 26, 27, and 28 as module input terminals, it should be noted that other kinds of module input terminals are also provided such as one for various signals (e.g. clock signals, preset signals, countdown clock signals), one for a ground, and one for display unit power source.

In the present embodiment, the module input terminals 26, 27, and 28 are disposed alonq the right and left sides of the sheet-like base member 20a, in series in the column direction. Each of the electrode terminal is disposed so as to extend from the upper surface of the substrate over to the rear surface of the substrate and be U-shaped in a cross sectional view. Each of the module input terminals 26, 27, and 28 has an exposed portion on the rear-surface side of the sheet-like base member 20a. When the display apparatus has been assembled together, these exposed portions oppose the substrate output terminals 36, 37, and 38, which are provided on the main wiring substrate 30 and will be mentioned later.

The wirings 23 connect the drive element 21 with the upper-side ends of the module input terminals 26, 27, and 28. The wirings 24 allow connection between drive elements 21 that are positioned in series in the row direction on the sheet-like base member 20a. These wirings 23 and 24 are for supplying various signals (e. g. image signals, chip select signals), a ground, a module electric power source, and so on, from the module input terminals 26, 27, 28 to the drive elements 21. The wirings 23 and 24 correspond to the second wiring.

The wirings 25 connect the drive elements 21 with the module output terminals 22 and are for transmitting drive signals for driving the display elements 11.

As shown in FIG. 4, the electrode terminals 29 are provided on the edges of the module substrate 20, more specifically on the corner portions of the module substrate 20. When the assembly is completed, the electrode terminals 29 are connected with the transparent conductive film 13 andmaintain the electric potential of the transparent conductive film 13 at the display unit-ground level.

As will be explained later, it is acceptable that the electrode terminals 29 are provided at any of the positions selected as electricity supplying points for the display unit 10. It is not necessary that all the module substrate 20 have electrode terminals on the edges thereof in the same manner.

The sheet-like base member 20a can be made of a thermosetting resin, for example, a glass epoxy resin, which has been conventionally used.

Alternatively, it is acceptable to use an electrically insulative material in which an inorganic filler is mixed with a thermosetting resin. Alumina and silica are specific examples of inorganic fillers.

Generally speaking, an inorganic filler has better heat conductivity than a thermosetting resin and is therefore able to make the heat conductivity of the module substrate 20 better. When the module substrate 20 has good heat conductivity, even if heat is generated in the display unit 10, it is possible to release the heat efficiently.

By adjusting how much inorganic filler is included in the sheet-like base member 20a, it is possible tomake the thermal expansion coefficient thereof closer to that of the transparent insulative substrate 12. Accordingly, it is also possible to lessen warping of the display apparatus 1 caused by the changes in the temperature; therefore, it is possible to realize a display apparatus with high reliability.

As for the ratio of inorganic filler included in the sheet-like base member 20a, it would be desirable to arrange it to be within a range of 70 to 95 weight%.

It should be noted that, when the number of drive elements 21 disposed in series in the row direction on the module substrate 20 is small, it is easy to connect each drive element 21 with the module input terminals 26 to 28 positioned adjacent thereto by the wiring 23; therefore, it is not necessary to provide the wiring 24 for connecting one drive element 21 with another drive element 21. For example, in a case of the module substrate 20 shown in FIG. 4, only two drive elements 21 are disposed in series in the row direction, and each drive element 21 is connected to the module input terminal 26 to 28 positioned adjacent thereto via the wiring 23; therefore, even without providing the wiring 24, it is possible for each drive element 21 to receive electricity and signals from the main wiring substrate 30.

Conversely, when the number of the drive elements 21 disposed in series in the row direction is large, it is desirable to provide the wiring 24 for connecting one drive element 21 with another drive element 21. In other words, when three or more drive elements 21 are disposed in series in the row direction on a module substrate 20, it is desirable to provide the wiring 24 for connecting those three of more drive elements 21 together, as well as to supply electricity and signals from the main wiring substrate 30 to the drive element 21 positioned at the center via the wiring 24.

### Structure of the Drive Elements 21

As for an IC chip element to be used as a drive element 21, it is suitable to use one having a driving circuit that is able to perform processes required for driving the display unit. Further, it would be preferable to use one with the following features.

When the size of the drive element 21 is large, it would be difficult to keep sufficient space for providing electrode terminals and wirings on the upper surface of the module substrate 20; therefore, using an IC element, which is relatively smaller in size, it is possible to keep sufficient space for providing electrode terminals and wirings on the upper surface of the module substrate 20.

In addition, it is easy to provide the drive elements 21, the module output terminal 22, and the wirings 23, 24, and 25 on the upper surface of the substrate. Accordingly, it is possible to keep the manufacturing process of the module substrates simple, and keep the manufacturing cost low.

By using an IC element formed with monocrystal silicon, LSI, or the like as a drive element 21, it is possible to allow each drive element to include, as built-in functions, not only the driving circuit for driving the display unit, but also a signal processing unit, a memory, and so on. Accordingly, in response to the image signals supplied by a driving device, the drive elements 21 are each able to answer the need of performing complicated processing.

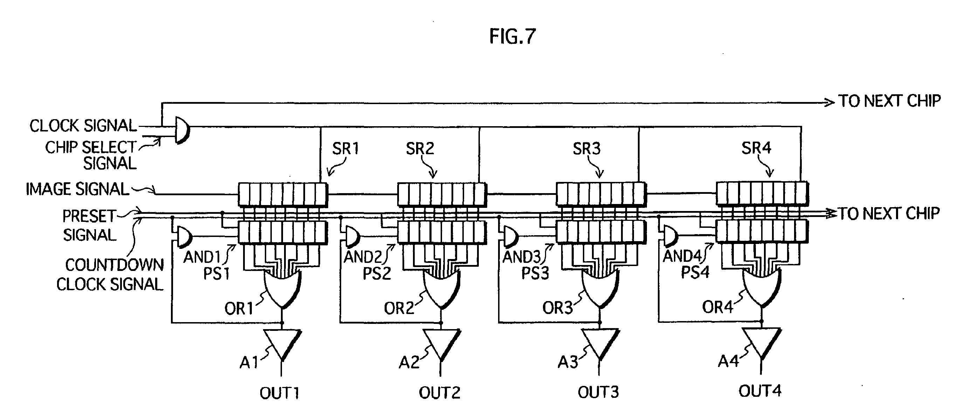

For example, when the image signals transmitted to the drive elements 21 are digital signals, it is possible to have such a signal processing unit performa D/A conversion processing so as to convert the digital image signals. Alternatively, it is also possible to have such a signal processing unit perform preprocessing of the image signals (e.g. γ correction). Further, it is possible to have such a memory temporarily store image signals that have been transmitted thereto. Specific examples of such IC elements will be explained later with reference to FIG. 7.

As the drive element 21, it is acceptable to use, instead of an IC element, a driver substrate, which is made of thin film transistors (TFTs) formed in an array.

As for such TFTs, it would be desirable to use low-temperature polysilicon TFTs.

Polysilicon films have high mobility and are able to form a drive element that is small in area size and has high driving capability; therefore, when low-temperature polysilicon TFTs are formed, it is possible to achieve, by a relatively small-sized element, switching characteristics with low resistance. Thus, they contribute to displaying an image evenly in the whole display unit and also to reduction in electricity consumption.

### Structure of the Main Wiring Substrate

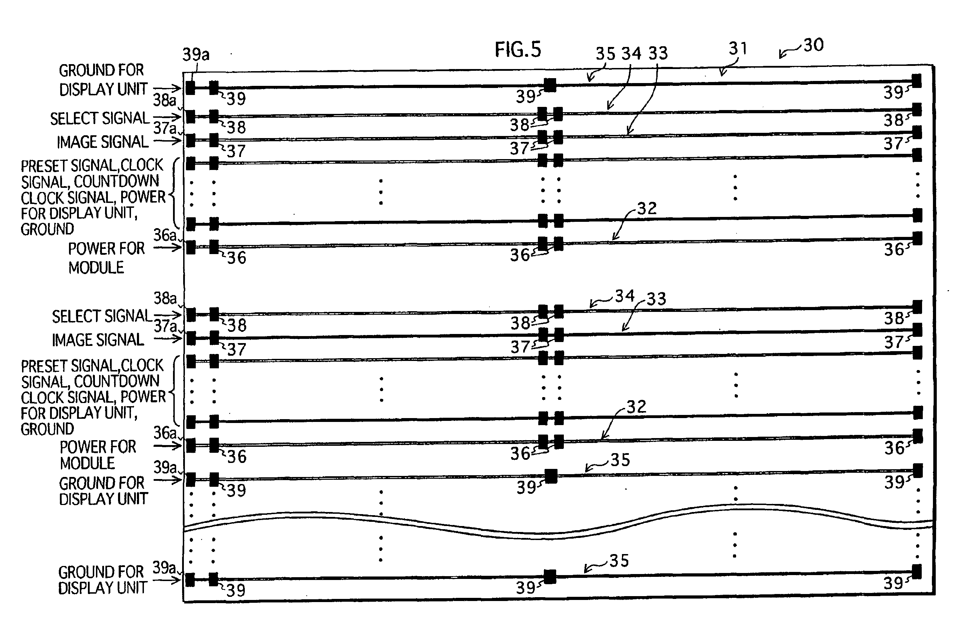

FIG. 5 is a plan view of the main wiring substrate 30, being view from the upper-surface side.

The main wiring substrate 30 has a structure in which (i) the module substrates 20, (ii) the wirings 32 to 35 which serve as the first wiring and are for supplying electricity and various signals to the display unit 10, as well as (iii) the substrate output terminals 36 to 39 which are connected to these wirings are provided on the upper surface of the base substrate 31.

As for the base substrate 31, it is acceptable to use the same material of which the transparent insulative substrate 12 is made, or alternatively to use other kinds of metal substrate or resin substrate. As for a metal substrate, examples include an aluminum plate, a copper plate, a steel plate, and the like, on which an insulation film is formed on the surface thereof. As for a material of which the resin substrate may be made, examples include glass epoxy, PET, polyimide plate, and so on.

All of the wirings 32 to 35 each extend in the row direction. On an end of the wirings 32 to 35, the substrate input terminals 36a to 39a are provided, respectively, in order to make connection with a module driving power terminal, an image signal terminal, a chip select signal terminal, and a display-unit ground terminal of an external driving device.

When the assembly is completed, the wiring 32 is connected to the module driving power source via the substrate input terminal 36a; the substrate output terminal 36 is connected with the module input terminal 26 on the module substrate 20 side, so as to supply electricity from the module driving power source to the module substrates. To the wiring 33, image signals are supplied via the substrate input terminal 37a. The substrate output terminal 37 is connected with the module input terminal 27 on the module substrate 20 side, so as to supply the image signals to the module substrates 20. To the wiring 34, chip select signals are supplied via the substrate input terminal 38a. The substrate output terminal 38 is connected with the module input terminal 28 on the module substrate 20 side, so as to supply the chip select signals to the module substrates 20. The wiring 35 is connected to the display-unit ground via the substrate input terminal 39a. The substrate output terminal 39 is connected to the electrode terminal 29 on the module substrate 20 side, so as to keep the electric potential of the transparent conductive film 13 at the ground level.

It should be noted, as shown in FIG. 5, that other wirings and electrode terminals for supplying various signals (e. g. clock signals, preset signals) , grounds, and display-unit power source to the module substrates 20 are also provided on the base substrate 31.

The substrate output terminals 36 to 39 are disposed so as to oppose the terminals 26 to 29 provided on the module substrate 20 when the assembly is completed; therefore, making connection therebetween is easy.

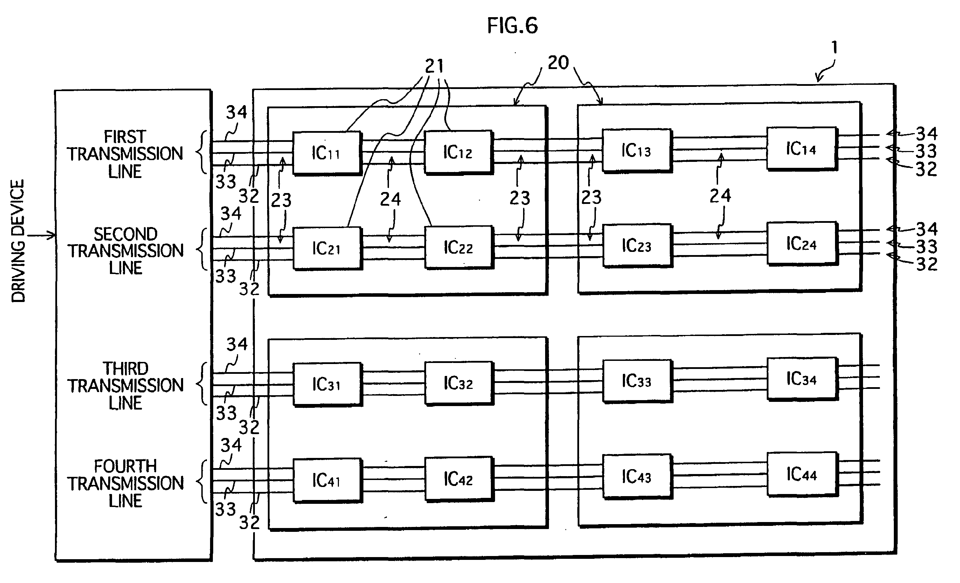

Although the bottom part of the main wiring substrate 30 is omitted from the drawing FIG. 5, the drive elements 21 are disposed in a matrix of 4 rows by 4 columns in the display apparatus 1 of the present embodiment (see FIG. 6), four transmission paths each being made up of the wirings 32 to 34 are provided on the main wiring substrate 30. Each transmission path is for supplying electricity and signals to four drive elements 21 that are disposed in series in the row direction.

### Connection between electrodes and sealing of electrodes

When the assembly is completed, the display unit terminals 15 in the display unit 10 and the module output terminals 22 on the module substrate 20 are joined together via a conductive adhesive layer 91, which is made of an electrically conductive adhesive. The terminals 26 to 29 on the module substrate 20 and the substrate output terminals 36 to 39 on the main wiring substrate 30 are joined together via a conductive adhesive layer 92. With these arrangements, joining of substrates and the electric connection between the opposing terminals are ensured.

Here, when the display unit terminal 15 and the module output terminal 22 are joined together, it is acceptable to insert a spacer between the display unit 10 and the module substrates 20 in order to avoid (i) electrical contact between the transparent conductive film 13 and the module output terminals 22 or the wirings 23 to 25 on the module substrate 20 and (ii) unnecessary electrical contact between the display unit terminals 15 and the wirings on the module substrate 20 (i.e. the wirings 23 and 24).

It should be noted, however, that the number of wirings on the module substrate 20 is not so large, and the sizes of the display unit terminals 15 and the module output terminals 22 are allowed to be relatively large; therefore, it is possible to ensure the required electric connection while avoiding unnecessary electric contact, only by joining those terminals with each other by an electrically conductive adhesive.

The transparent insulative substrate 12 of the display unit 10 and the main wiring substrate 30 are equal in size, and a sealing portion 95 is provided in the whole periphery areas around those substrates. With this arrangement, since the internal space sandwiched by the transparent insulative substrate 12 and the base substrate 31 is hermetically sealed, the display elements 11 including organic EL films, the module substrates 20, and the like are protected from exposure to the air outside. Organic EL films tend to deteriorate by humidity when they are in contact with the air outside. Also, bare IC chips that can be used as the drive elements tend to deteriorate. By protecting them from exposure to the air outside as above, it is possible to inhibit deterioration due to humidity, and thereby achieve a display apparatus with high reliability. Further, it is also acceptable to fill up the internal space with resin or the like.

### Technical Features of the Wirings in the Display Apparatus 1

FIG. 6 shows the arrangement of the drive elements 21 and how the wirings are provided therebetween in the display apparatus 1.

In the display apparatus 1, as explained above, the display unit 10, the module substrate 20, and the main wiring substrate 30 are pasted together and also electrically connected with one another. With this arrangement, as shown in FIG. 6, the drive elements 21 (IC 11 to IC 44) are disposed in a matrix of four by four in the row and column directions. The drive elements 21 positioned in series in the row direction are connected via the wirings 32 to 34 (the first wirings) provided on the main wiring substrate 30 and the wirings 23 and 24 (the second wirings) provided on the module substrate 20. With these wirings, the aforementioned four transmission paths for supplying electricity and signals to the drive elements 21 are provided.

In the display apparatus 1, since the wirings 32 to 35 and the wirings 23 and 24 for supplying electricity and signals to the drive elements 21 are provided on the main wiring substrate 30 and the module substrate 20 separately rather than on the display unit 10, it is possible to have sufficient space for wirings compared to a case where wirings are provided in the display unit.

Further, the drive elements 21 for driving the display elements 11 are provided on the module substrates 20 which are separate from the display unit 10 and are connected to the display elements 11 via the wiring 25, the module output terminals 22, and the display unit terminals 15; therefore, there is no need to provide wirings on the display unit 10. Accordingly, the structure of the display unit 10 is simple.

### Electricity Supply to the Display Unit 10

The aforementioned electricity supplying points are the points at which the wiring 35 for the display-unit ground on the main wiring substrate 30 is electrically connected with the transparent conductive film 13 in the display unit 10 (i.e. the points at which electricity is supplied to the display unit 10). These points are selected from among the points where the corners of the module substrates 20 are positioned, so that these points are dispersed throughout the display apparatus 1.

In the example shown in FIG. 2, in the display apparatus 1 as a whole, there are nine points in total (P1 to P9) at which the corners of the module substrates 20 are positioned. Here, it is assumed that all these points are selected as electricity supplying points; however, it is not necessary to select all of them. For example, in a case where a large number of module substrates 20 are disposed, since there are a large number of points at which the corners of the substrates are positioned, it is acceptable to select some of them as electricity supplying points so that they are appropriately apart from each other.

At the electricity supplying points P1 through P9, the substrate output terminals 39 are provided on the main wiring substrate 30, and the substrate output terminals 39 are connected with the electrode terminals 29 via conductive adhesive layers (not shown in the drawing). Also, the electrode terminals 29 are connected with the transparent conductive film 13 via conductive adhesive layers (not shown in the drawing).

When the electrode terminal 29 is connected with the transparent conductive film 13, in a case where there is enough space between two display elements 11 that are positioned adjacent to each other, it is appropriate to provide the conductive adhesive layer in that space. In a case where the space therebetween is small, it is acceptable to make a display unit terminal 15 electrically continuous with the transparent conductive film 13 at a display element 11 positioned at one of the electricity supplying points, and then connect this display unit terminal 15 with the electrode terminal 29 via a conductive adhesive layer.

By arranging the electricity supplying points so that they are dispersed throughout the whole display field, the following effects are achieved.

Normally, since the transparent conductive layer 13 has high resistance, a power loss is caused when electricity is supplied to a display element positioned away from an electricity supplying point. For example, in a case where the electricity supplying points for the transparent conductive film 13 are provided only in the peripheral area, a power loss is caused when electricity is supplied to a display element positioned in the central area of the transparent conductive film 13. Particularly, when the display screen is large, a power loss is easily caused because the distance between the peripheral area and the central area is long. Such power losses could be a cause of image quality degradation. Conversely, when electricity supplying points are positioned so that they disperse throughout the whole display field, all of the display elements have electricity supplied from an electricity supplying point positioned in the vicinity, it is possible to inhibit power losses. Thus, it is possible to prevent image quality degradation.

### Image Display Action in the Display Apparatus 1

The following explains an example of image display action in the display apparatus 1, with reference to FIGs. 5 and 6.

The module driving power source is connected from the substrate input terminals 36a to all of the drive elements 21 via the wirings 32, so that electricity for driving the modules is supplied to the drive elements 21.

In addition, the display-unit ground is connected from the substrate input terminals 39a to the transparent conductive film 13 via the wirings 35. Also, the display unit power source is connected from the substrate input terminals to all of the drive elements 21 via the wirings. Due to these arrangements of connection, it is arranged so that electricity for driving the display unit can be supplied between the transparent conductive film 13 and the display unit terminals 15 in the display elements 11.

Image signals, chip select signals, and other signals (clock signals, preset signals, countdown clock signals) are supplied to the drive elements 21 from the substrate input terminals 37a and 38a via the wirings 33 and 34.

Image signals may be either analogue signals or digital signals. For each frame, image signals are supplied in parallel by distributing them from an external driving device to the image signal wirings 33 of the four transmission paths (the first through fourth transmission paths in FIG. 6). To each of the image signal wirings 33 of the transmission paths, image signals for two lines are transmitted so as to be provided for the four IC chips that are disposed in series in the row direction. The reason why image signals for two lines are transmitted is because every four IC chips in one row are connected with display elements for two lines.

Through each of the transmission paths, image signals are transmitted by a time-division method to the four IC chips disposed in series in the row direction, via the image signal wiring 33. For this purpose, chip select signals are transmitted from the external driving device to the wirings 34 so as to match the timing at which the image signals are transmitted. The drive elements 21 (IC 11 to IC 44) are controlled with the chip select signals so as to receive the image signals.

With this arrangement, for each frame, the image signals for two lines that have been supplied to the wirings 33 of the transmission paths are appropriately distributed to the four drive elements 21 that are disposed in series in the row direction.

According to the image signals received, the drive elements 21 adjust the quantity of light emitted by the display elements 11, by controlling the electric power (one or both of the amount of electric current and the period of power supply) supplied to the display elements 11.

Here, the ground is connected to the transparent conductive film 13, and the display unit power source is connected to the display unit terminals 15 via the drive elements 21; however, it should be noted that it is equally possible to embody the present invention by having an opposite arrangement wherein the display unit power source is connected to the transparent conductive film 13, and the ground is connected to the display unit terminals 15 via the drive elements 21.

Further, here image signals are transmitted to the four transmission paths in parallel; however, it is also acceptable to have an arrangement wherein four transmission paths are connected in series and image signals for the lines of the whole screen are supplied to these transmission paths sequentially.

Additionally, it is also acceptable to provide wirings for transmitting image signals individually to each of the four IC chips disposed in series in the row direction; however, the number of wirings for image signals can be smaller when, as in the arrangement mentioned above, the image signal wiring 33 in common for transmitting image signals by a time-division method is provided.

### Specific Example of Structure and Image Display Action of the Drive Elements

FIG. 7 shows the circuit structure of an IC chip that could serve as one of the drive elements 21.

Here, in order to keep it simple, among the eight display elements driven by a drive element 21, only such a part of the circuit that drives the four display elements disposed in one line in the row direction is shown. The explanation below will be provided on an assumption that image signals for one line are supplied to four drive elements 21 disposed in series in the row direction.

As shown in FIG. 7, chip select signals and image signals are inputted to the gate portion of the IC chip. These image signals are 8-bit digital signals that can be displayed in a 256-level gray scale. In the IC chip, shift registers SR1 to SR4, present counters PS1 to PS4, OR circuits OR1 to OR4, AND gate AND1 to AND4, amplification circuits A1 to A4, are provided in correspondence to four display elements. The outputs OUT1 to OUT4 from the amplification circuits A1 to A4 are transmitted to the display elements 11 via the four module output terminals 22.

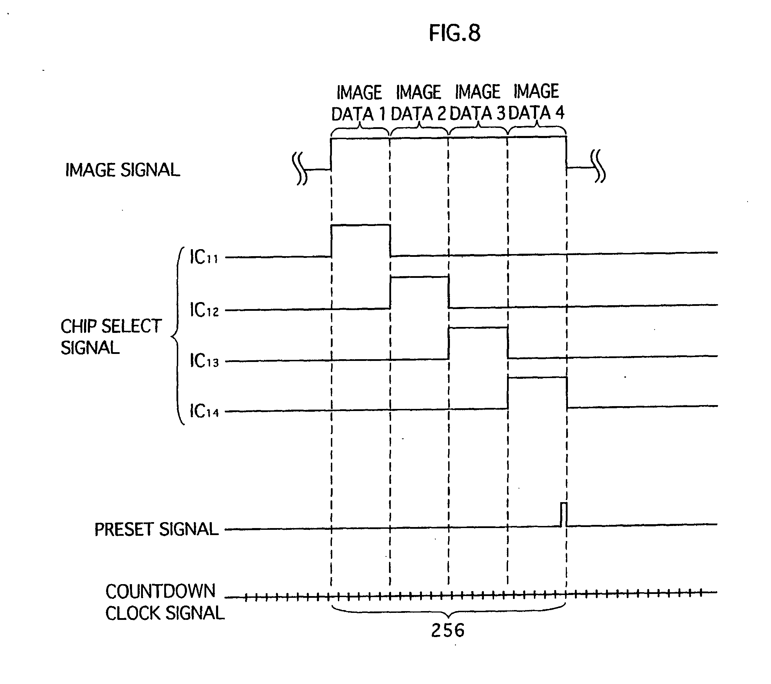

FIG. 8 shows the timing at which an external driving device supplies image signals, chip select signals, and preset signals to the drive elements via the transmission paths. This drawing illustrates the first transmission path, but the arrangements for the second through fourth transmission paths are the same.

As shown in FIG. 8, the image signals transmitted from the external driving device are distributed in the following manner: the image data 1 (8 bits) to be processed at the IC 11; the image data 2 (8 bits) to be processed at the IC12; ... and the image data 4 (8 bits) to be processed at IC14. This distribution is made in accordance with chip select signals. Those pieces of 8-bit data that have been distributed are temporarily stored in the shift register SR1 to SR4, respectively. At a stage when data for one line has been accumulated, preset signals are provided to the preset counters PS1 to PS4, and the pieces of data stored in the shift registers SR1 to SR4 are transferred to the preset counters PS1 to PS4 in parallel and stored as preset values. Since a countdown clock is provided for each of the preset counters PS1 to PS4, the preset values are counted down. Until the count values of the preset counters all become zero, one or more of digits of the preset counters PS1 to PS4 are one, and the outputs are made via the OR circuits. In other words, each of the preset counters PS1 to PS4 outputs "1", while counting a clock signal corresponding to the preset value. As a result, the data value is converted to a length of time. The outputs from the OR circuits are voltage-amplified in the amplification circuit A1 to A4, and applied to the display elements. Thus, each display element is turned on with an appropriate quantity of light emission in accordance with the image data. As long as one or more of the digits are one, "1" is inputted to the AND gates AND 1 and so on via the OR circuits, to keep the gates open. Accordingly, until the values of the preset counters all become zero, the countdown clock is supplied to each preset counter via an AND gate. When the counter value has been counted down to zero, "0" is supplied to the AND gate via the OR circuit, the AND gate closes and then the preset signal is turned on, and the countdown clock stops counting until image data is transferred from a shift register.

Here, explanation has been provided on an assumption that image signals for one line are supplied to the four IC chips disposed in series in the row direction; however, by having an arrangement wherein image signals for two lines are supplied in parallel so that the IC chips process such image data in parallel, the four IC chips disposed in series in the row direction are able to drive the display elements for the two lines.

Further, in the aforementioned embodiment, chip select signals are used in the control so that pieces of image data are distributed to the four IC chips sequentially; however, it is also acceptable that, without using chip select signals, image signals are supplied in serial to the four shift registers SR1 to SR4, and when image signals for one line have been supplied, the pieces of data accumulated in the shift registers SR1 to SR4 are transferred in parallel to the preset counters. With this arrangement, there is no need of chip select signals, and the wiring pattern would have more room.

### Manufacturing Method of the Display Apparatus 1

### Manufacturing of the Display Unit 10:

On the rear surface of the transparent insulative substrate 12, a transparent conductive material, such as ITO, is formed into a thin film by the sputtering method, the vacuum deposition method, or the sol-gel method, so as to form the transparent conductive film 13. Then, the organic EL films 14 are made over it with organic EL film materials that are for light emission in different colors, by the ink jet method or the vacuum deposition method with a metal mask. With this manufacturing method, it is possible to dispose films at different positions in stripes easily. As additional information, each of the organic EL films 14 often has a plurality of layers in actuality, and there are various manufacturing methods; however, explanation will be omitted since there is not much influence on the main gist of the present invention.

The display unit terminals 15 are prepared by, for example, patterning a conductive metal material with a mask while forming it into films by the vacuum deposition method.

### Manufacturing of the Module Substrates 20:

Trapezoidal depressions are made on the upper surface of the sheet-like base member 20a, which is a resin sheet. After silicon IC chips to serve as the drive elements 21 are processed into substantially the same shapes as the aforementioned depressions, the silicon IC chips are embedded into the depressions. The shapes of the depressions are arranged so that the exposed surface of each IC chip is flush with the surface of the sheet-like base member 20a.

Then, the wirings 23, 24, 25, and the module output terminals 22 are formed on the upper surface of the sheet-like base member 20a, either by (i) forming a metal material such as copper or aluminum into a film by a thin film manufacturing method such as deposition, and then patterning the metal film or (ii) patterning a metal material by plating.

As additional information, as for a technique that is applicable to the manufacturing of module substrates, Roger G. Steward, "Ultra-low Power AMLCDs" Proceeding of Society for Information Display 2001 International Symposium, p. 264 (2001) cites a technique by which, in some liquid, more than ten thousand compact semiconductor chips that are smaller than 0.5 mm square are embedded into depressions in a substrate and wired per second.

The module input terminals 26, 27, 28, and the electrode terminals 29 can be formed by, for example, printing and hardening a conductive paste.

### Manufacturing of the Main Wiring Substrate 30:

The main wiring substrate 30 can be prepared by forming the wirings 32 to 35 and the substrate output terminals 36 to 39 on the base substrate 31 by, for example, pattern-printing and hardening a conductive paste.

Here, in order to manufacture the main wiring substrate 30, it is acceptable to use, as the base substrate 31, a substrate that is equal in size with the transparent insulative substrate 12. Alternatively, it is also acceptable to prepare a plurality of base substrates that have divisional sizes and paste them together. For example, it is acceptable to prepare wiring substrate units by dividing the main wiring substrate 30 shown in FIG. 5 into two or four pieces along the wirings 32 to 35 and paste these wiring substrate units together, like tiles, in the assembly steps explained below.

### Assembly of the Display Apparatus 1:

The module substrates 20 are pasted in the areas of the display unit 10. At this time, the modules substrates 20 are pasted while the display unit terminals 15 are electrically connected with the module output terminals 22 with an electrically conductive adhesive.

As for electrically conductive adhesives, normally used is one in which a silver filler is dispersed within epoxy resin. Here, by using an electrically conductive adhesive, it is possible to make connection for a large number of terminals all at once, without applying high heat or pressure. Additionally, since there is no need to form bumps or the like for making connection, it is possible to keep the work simple.

More specifically, a conduct adhesive in the form of a paste is printed by, for example, a screen-printing method on the display unit terminals 15 in the display unit 10 or the module output terminals 22 on the module substrates 20. After that, by positioning and pasting the module substrate 20 onto the display unit 10, it is possible to electrically connect, as well as to adhere and fix, the display unit terminals 15 with the module output terminals 22. By repeating this process, a plurality of module substrates 20 are pasted side by side onto the display unit 10.

After the module substrates 20 are connected with the display unit 10, operational actions of the apparatus will be tested. This testing process will be described in detail later.

Next, through the process of positioning and pasting the substrate output terminals 36 to 38 on the main wiring substrate 30 with the module input terminals 26 to 28 on the module substrate 20 via an electrically conductive adhesive, these substrates are joined and, at the same time, electrically connected.

As additional information, in order to paste the main wiring substrate onto the module substrates more firmly, it is acceptable to apply an adhesive also in some areas, besides on the terminals. In such a case, the adhesive to be used does not have to have conductivity.

Further, a sealing paste is applied at the periphery areas around the main wiring substrate 30 and the transparent insulative substrate 12, so as to form the sealing portion 95. Thus, the display apparatus 1 is manufactured.

### Checking for good and bad products

When the module substrates 20 have been manufactured, it is possible to check if the module substrates 20 themselves are good or bad by providing a probe for the module input terminals 26 to 28 on each module substrate 20 and applying a predetermined electric signal thereto so as to check the outputs from the module output terminals 22.

Accordingly, it is extremely effective in improvement of the yield of the assembly process to check for good and bad products before pasting the module substrates 20 onto the display unit 10 so that only good module substrates are pasted.

Further, after the module substrates 20 are joined with the display unit 10, it is possible to examine if the display elements 11 driven by the module substrate 20 emit light properly by providing a probe for the module input terminals 26 to 28 on the module substrate 20 and applying a predetermined electric signal thereto. When some abnormality is found in this test, the module substrate 20 can be replaced with another one. When the cause of the abnormality is a defect in the module substrate 20 or the mal-connection between the module substrate and the display unit 10, normal actions can be achieved by replacement of the module substrate 20.

### Basic Effects achieved by the Structure and the Manufacturing Method of the Display Apparatus 1

As explained so far, in the display apparatus 1, the display elements 11 in the display unit 10 are driven dot by dot by the drive elements 21 provided on the module substrate 20. Also, the supply of electricity and signals to the module substrate 20 and the supply of electricity to the display unit 10 are made via the main wiring substrate 30 disposed so as to cover the module substrate 20.

Accordingly, it is possible to achieve, with a simple structure, a flat and large-sized display apparatus in which a dot drive method is used. Further, it is possible to achieve an organic EL display apparatus that is large-sized with a screen of meters by meters and extremely flat.

In addition, when the substrates are ones having flexibility, it is possible to manufacture a flexible display apparatus. For instance, it is possible to achieve a display apparatus that is large-sized and can be rolled up.

Additionally, since the electricity and signals for driving the display unit 10, including the electric connection to the transparent conductive film 13, are supplied from the main wiring substrate 30, it is possible to provide, on the main wiring substrate 30, all the connection between the display apparatus 1 and a driving device (an external circuit), which drives the display apparatus 1, for electric power and signal lines.

As for the manufacturing method, the display apparatus 1 is manufactured by, as mentioned above, manufacturing each of the display unit, the module substrate, and the main wiring substrate separately, and pasting them sequentially. Further, since there are no drive elements provided in the display unit 10, the manufacturing is easy and there is no need of tile pasting process.

Furthermore, even if there is a defect in the module substrate 20 or a mal-connection between the module substrate 20 and the display unit 10, it is possible to manufacture a good product by replacing only the part with a defect. Accordingly, even when the display apparatus 1 is large-sized, it is possible to have production with a high yield.

### Modification Examples

In the present embodiment, the organic EL films are formed in stripes in the display unit 10; however, the present invention is not limited to this arrangement, and it is also acceptable that, for example, the organic EL films are separately formed apart from one another, like the display unit terminals 15.

As for the manner in which the display elements are disposed in the display unit 10, in the present embodiment, an example has been presented where the display elements are disposed in a matrix in the column and row directions; however, it is acceptable as long as there are one or more areas in which the display elements are disposed in an array.

For example, it is acceptable if the display unit has a delta arrangement pattern, or if the display unit has only one line of array arrangement in the row direction.

In the present embodiment, explanation has been provided on an apparatus that achieves color display with the use of organic EL films emitting light in different colors; however, the present invention can be applied to a display apparatus with single color light emission. As additional information, in case of single color light emission, the organic EL films do not need to be formed in stripes, and they can be formed in a solid pattern over the whole surface like the transparent conductive film.

### Second Embodiment

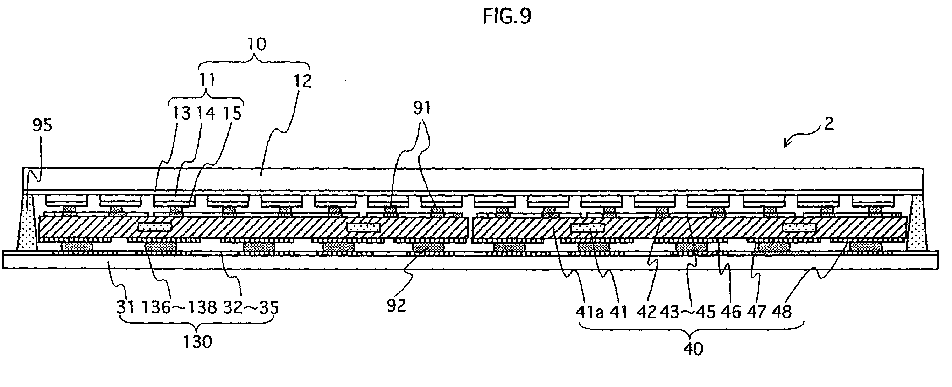

FIG. 9 is a schematic cross-sectional view of the display apparatus 2 of the second embodiment. The constituent elements that are the same as in FIG. 1 have the same reference characters.

The display unit 10 has the same structure as in the first embodiment.

Like the module substrate 20 in the first embodiment, the module substrate 40 used in the display apparatus 2 includes a sheet-like base member 40a on which the drive elements 41, the module output terminals 42 to be electrically connected with the display unit terminals 15, the module input terminals 46 to 48 to be connected with the substrate output terminals 136 to 138 on the main wiring substrate 30, the wiring 43 for connecting the drive elements 41 with the module input terminals 46 to 48, the wiring 44 for connecting one drive element 41 with another drive element 41, and the wiring 45 for connecting the drive elements 41 with the module output terminals 42 are provided.

It should be noted, however, that in the module substrate 40, the drive elements 41 are embedded at deeper positions than the surface portion of the sheet-like base member 40a, in other words, in the central portion in the thickness direction.

Further, the module input terminals 26 to 28 in the first embodiment are provided on the sides (the row direction) of the sheet-like base member 20a; however, the module input terminals 46 to 48 in the present embodiment are provided so as to disperse throughout the rear surface of the sheet-like base member 40a. In addition, FIG. 9 shows that the module input terminals 46 to 48 are disposed in series in the row direction; however it is also acceptable that they are disposed so as to disperse in the column direction on the rear surface of the sheet-like base member 40a.

Additionally, the wirings 43, 44, and 45 are provided not only on the surface of the sheet-like base member 40a, but also extending over to the inside, in the thickness direction, and the rear surface of the sheet-like base member 40a, so as to form a multi-layer wiring structure.

The main wiring substrate 130 basically has the same structure as the main wiring substrate 30 in the first embodiment. On the upper surface of the base substrate 31, the wirings 32 to 35 and the substrate output terminals 136 to 139 that are connected thereto are provided; however, the positions of the module input terminals 46 to 48 are slightly different from the positions of the module input terminals 26 to 28 in the first embodiment, and thereby the positions of the substrate output terminals 136 to 138 are slightly different likewise.

Silicon IC chips that have the same functions as the drive elements 21 of the first embodiment are used as the drive elements 41. It should be noted, however, that it is also acceptable to provide, in addition to such IC chips, other parts (resistances, capacitors, coils, and the like) so as to distribute functions required for driving the display elements to them.

As for the electric connection between the wiring 35 for the display-unit ground and the transparent conductive film 13, like in the first embodiment, it would be suitable if, at the electricity supply points, the electrode terminals 29 are provided so as to extend from the upper surface side over to the rear surface side, at the corners of the module substrates 40 so that connection is made via these electrode terminals 29.

### Structure of the Module Substrate 40

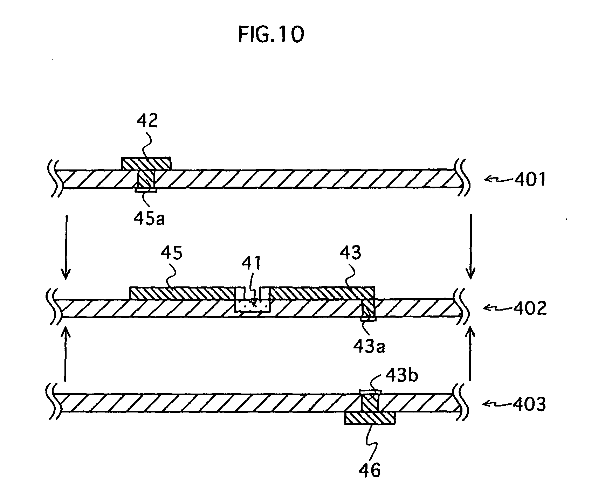

FIG. 10 schematically shows the structure of the module substrate 40.

As shown in FIG. 10, the module substrate 40 has a multi-layer wiring structure in which a plurality of wiring sheets (here, three sheets such as an upper-surface side sheet 401, a center sheet 402, a rear-surface side sheet 403) are laminated.

As for the upper-surface side sheet 401, module output terminals 42 are arranged on the upper surface of the sheet-like base member.

As for the rear-surface side sheet 403, the module input terminals 46 to 48 are arranged on the rear surface of the sheet-like base member (in FIG. 10, only the module input terminal 48 is shown as a representative).

As for the center sheet 402, depressions are formed on the surface portion of the sheet-like base member, and the silicon IC chips serving as the drive elements 41 are embedded therein.

The wirings 43, 44, and 45 are provided on the upper surfaces and the rear surfaces of the sheets 401, 402, and 403, and either via holes or through holes are provided on the sheets, as necessary.

For example, in FIG. 10, the wiring 43 is drawn from the input pad of the drive element 41 along the upper surface of the center sheet 402, while the wiring 43 is connected with the module input terminal 46 by the via holes 43a and 43b, which are through holes that go through the center sheet 402 and the rear-surface side sheet 4 03 and are filled with conductive paste. This way, the drive element 41 and the module input terminal 46 are electrically connected with each other, as shown in the drawing.

As the drawing further shows, the wiring 45 is drawn from the output pad of the drive element 41 along the upper surface of the center sheet 402, while the wiring 45 is connected with the module output terminal 42 by the via hole 45a, which is a through hole that goes through the upper-surface side sheet 401. This way, the drive element 41 and the module output terminal 42 are electrically connected with each other, as shown in the drawing.

As additional information, although the wiring 44 to connect one drive element 41 with another drive element 41 is now shown in FIG. 10, it is acceptable to provide it, for example, on the upper-surface side of the center sheet 402.

As explanation has been provided on the sheet-like base member 20a of the first embodiment, also for the sheet-like base members of the sheets 401, 402, and 403 in the module substrate 40, it would be desirable to use an electrically insulative material in which a thermosetting resin is mixed with an inorganic filler, in order to enhance the heat conductivity as well as to adjust the thermal expansion coefficient.

### Manufacturing Method of the Display Apparatus 2

The module substrate 40 can be manufactured by preparing and each of the upper-surface side sheet 401, the center sheet 402, and the rear-surface side sheet 403, and pasting them together.

The way in which the display apparatus 2 is assembled is substantially the same as the one in the first embodiment.

Specifically, a plurality of module substrates 40 are pasted onto the rear surface of the display unit 10, and the display unit terminals 15 are electrically connected with the module output terminals 42 with an electrically conductive adhesive.

Then, a probe is provided for the module input terminals 46 to 48 and a predetermined electric signal is applied to these module input terminals so as to drive the display element 11 to emit light. Thus, it is judged if the assembly is good or bad, and in case the assembly is bad, the module substrate 40 will be replaced.

After that, the main wiring substrate 103 is pasted, and the substrate output terminals 136 to 138 are electrically connected with the module input terminal 46 to 48 with an electrically conductive adhesive.

Further, a sealing portion 95 is injected in the periphery areas around the main wiring substrate 30 and the transparent insulative substrate 12 so as to hermetically seal them. Thus, the display apparatus 2 is manufactured.

### Effects achieved in the Present Embodiment

In addition to the basic effects that have already been explained in the first embodiment, the present embodiment further has the following effects:

In the module substrate 40, the drive elements 41 (IC chips) are embedded into the inside of the substrate in the thickness direction thereof and are not exposed on the upper surface or the rear surface. Thus, it is possible to make the surface of the module substrate 40 even flatter.

Further, since the module substrates 40 each have a multi-layerwiring structure, the degree of freedom of the wiring patterns is high.

### Third Embodiment

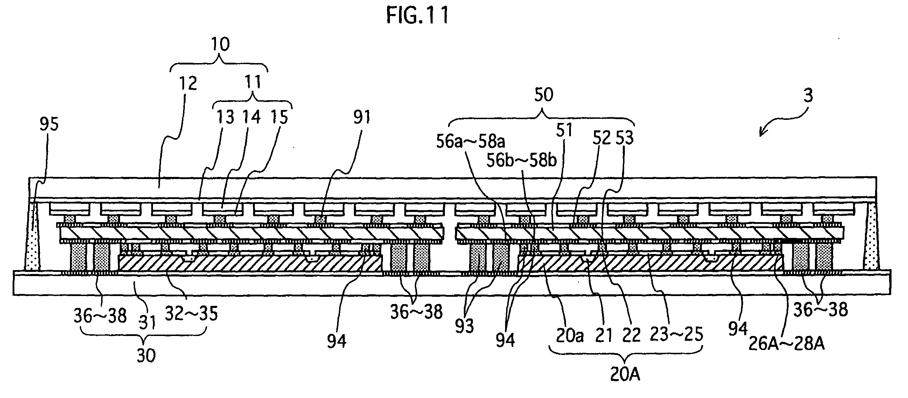

FIG. 11 is a schematic cross-sectional view of the display apparatus 3 of the third embodiment.

In the display apparatus 3, the structures of the display unit 10 and the main wiring substrate 30 are the same as those in the display apparatus 1 of the first embodiment. In FIG. 11, those constituent elements that are the same as in FIG. 1 have the same reference characters.

In the present embodiment, the difference from the display apparatus 1 is that a relay substrate 50, which is a substrate that relays, is inserted between the display unit 10 and the module substrate 20A, so that the electric connection between the display unit 10 and the module substrate 20A is made via the relay substrate 50. In addition, another difference from the display apparatus 1 is that the electric connection between the main wiring substrate 30 and the module substrate 20A is also made via the relay substrate 50.

The structure of the module substrate 20A is substantially the same as that of the module substrate 20 of the first embodiment (FIG. 4) ; however, in order to ensure space (the relay areas 502 to be described later) for electrically connecting the main wiring substrate 30 with the relay substrate 50, the module substrate 20A is arranged to have a smaller size than the module substrate 20. In other words, as shown in FIG. 2, the module substrate 20 has a size that is equal to the size of the area on the substrate in which the display elements 11 driven by the drive element 21 are disposed, while the module substrate 20A has a size smaller than the size of that area.

Accordingly, an arrangement is made wherein the pitch with which the module output terminals 22 are disposed in a matrix is also smaller that the pitch with which the display unit terminals 15 in the display unit 10 are disposed.

As additional information, FIG. 11 shows that the pitch with which the module output terminals 22 are disposed and the substrate size are smaller in terms of the row direction of the module substrate 20A; however, it is also acceptable to make the pitch and the substrate size smaller in the column direction as well.

Further, in the module substrate 20 in the first embodiment, the module input terminals 26 to 28 are provided so as to extend from the upper surface of the sheet-like base member 20a over to the rear surface thereof. In the module substrate 20A of the present embodiment, the module input terminals 26A to 28A are provided only on the upper surface and do not extend over to the rear surface, since they do not need to be in contact with the terminals provided on the main wiring substrate 30. Thus, it is possible to manufacture the module substrate 20A more easily in this regard.

### Structure of the Relay Substrate

The following explains in detail the structure of the relay substrate.

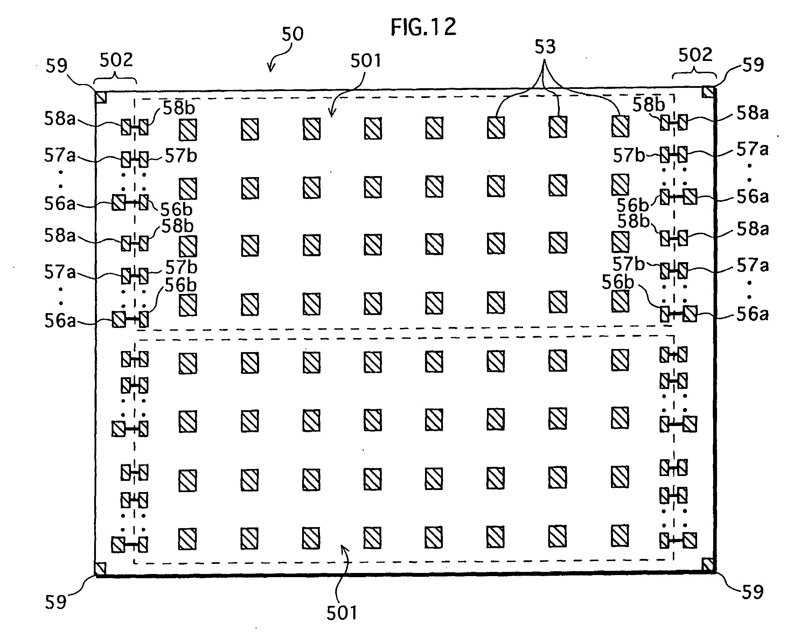

FIG. 12 is a plan view of the relay substrate 50, being viewed from the rear surface side (i. e. the side that opposes the module substrate).

The relay substrate 50 is a printed wiring substrate in which various electrodes and wirings mentioned below are formed on a sheet-like base member 51.

The relay substrate 50 has a size that is equal to the area on the substrate in which the display elements 11 driven by the drive element 21 are disposed. The relay substrate 50 has (i) pasting areas 501 in which a plurality of module substrates 20A are to be pasted and (ii) relay areas 502 provided on either sides of the pasting areas 501. FIG. 12 shows that two module substrates 20A can be pasted onto one relay substrate 50 so that they are positioned side by side in the column direction.

In the pasting areas 501, on the upper surface of the sheet-like base member 51 (the side that opposes the display unit), the upper-surface side electrode pads 52, which are exposed, are provided with a pitch that is the same as the pitch with which the display unit terminals 15 are disposed in the display unit 10. On the rear surface of the sheet-like base member 51, the rear-surface side electrode pads 53, which are exposed, are provided with a pitch that is the same as the pitch with which the module output terminals 22 are disposed on the module substrate 20A.

As additional information, although not shown in the drawing, via holes (not shown) that go through the sheet-like base member 51 are provided between the upper-surface side electrode pads 52 and their corresponding rear-surface side electrode pads 53. These electrode pads 52 and 53 are electrically connected by these via holes.

These via holes serve to connect the display unit terminals 15 with the module output terminals 22 while compensating the positional discrepancies, due to the pitch difference, between the display unit terminals 15 and the module output terminals 22. These via holes can be realized with the use of, for example, a technique for wiring substrates such as the one for inner via holes or through holes.

Further, in the relay areas 502 in the relay substrate 50, (i) relay electrode terminals 56a to 58a to be connected with the substrate output terminals 36 to 38 provided on the main wiring substrate 30 and (ii) relay electrode terminals 56b to 58b to be connected with the module input terminals 26A to 28A provided on the module substrate 20A are provided in order to make electric connection between the module substrate 20A and the main wiring substrate 30.

The relay electrode terminals 56a and 56b are for the module driving power source, the relay electrode terminals 57a and 57b are for image signals, and the relay electrode terminals 58a and 58b are for chip select signals.

The terminals that are positioned adjacent to each other (i.e. the relay electrode terminals 56a and 56b; the relay electrode terminals 57a and 57b; and the relay electrode terminals 58a and 58b) are connected to each other, and thereby such connecting electrodes that connect the substrate output terminals 36 to 38 with the module input terminals 26A to 28A are provided.

It is possible to manufacture the relay substrate 50 having the aforementioned structure at a very low cost with an ordinary technique for manufacturing double-sided printed wiring substrates.

### Material for the Sheet-like Base Member 51

The material used for the sheet-like base member 51 is the same as the material for the sheet-like base member 20a in the module substrate 20. For example, it may be a glass epoxy printed substrate or, as an example with high conductivity, an electrically insulative material into which an inorganic filler is mixed.

When the relay substrate 50 has high heat conductivity, even if heat is generated at the display unit 10, it is possible to release the heat efficiently.

Further, by adjusting how much inorganic filler is included in the sheet-like base member 51, it is possible to make the thermal expansion coefficient thereof closer to that of the transparent insulative substrate 12. Accordingly, it is also possible to lessen warping of the display apparatus 3 caused by the changes in the temperature; therefore, it is possible to realize a display apparatus with high reliability.

As for the ratio of inorganic filler included in the sheet-like base member 51, it would be desirable to arrange it to be within a range of 70 to 95 weight%.

### Connection between the Substrates

### Electric Connection between the Main Wiring Substrate 30 and the Module Substrate 20A:

As shown in FIG. 11, the relay electrode terminals 56a to 58a are electrically connected with the substrate output terminals 36 to 38 via conductive elastic members 93. The relay electrode terminals 56b to 58b are electrically connected with themodule input terminals 26A to 28Avia the conductive adhesive layers 94.

Accordingly, the substrate output terminals 36 to 38 provided on the main wiring substrate 30 are electrically connected with the module input terminals 26A to 28A provided on the module substrate 20A via the conductive elastic member 93, the relay electrode terminals 56a to 58a, the relay electrode terminals 56b to 58b, and the conductive adhesive layer 94, sequentially in the stated order. Accordingly, electric connection that is the same as the one in the first embodiment is provided between the main wiring substrate 30 and the module substrate 20A.

Here, the module substrate 20A is interposed between the main wiring substrate 30 and the relay substrate 50; therefore, there is a gap which is as large as the thickness of the module substrate 20A (for example, 0.1 mm to 1 mm approximately) between the substrate output terminals 36 to 38 and the relay electrode terminals 56a to 58a. It is, however, possible to achieve stable conductivity between those terminals by inserting the conductive elastic members 93 between them, as mentioned above.

As the conductive elastic members 93, it would be suitable to use stick-like members or ball-like members, which are made of plastic and easily go through elastic deformation, whose surfaces are processed by metallization so as to give electric conductivity. As other examples, it is also acceptable to use springy stick-like or ball-like members that are made of metal, or coil spring-shaped members.

As additional information, it is possible to manufacture the module substrate 20A so that it is 0.1 mm or thinner including the drive elements (IC elements). When that is the case, there is no need to use conductive elastic members.

### Electric connection between the Display Unit 10 and the Module Substrate 20A:

As shown in FIG. 11, the display unit terminals 15 in the display unit 10 are joined with the upper-surface side electrode pads 52 provided on the relay substrate 50 via the conductive adhesive layer 91. The rear-surface side electrode pads 53 on the relay substrate 50 are joined with the module output terminals 22 on the module substrate 20A via the conductive adhesive layer 94.

Accordingly, the module output terminals 22 provided on the module substrate 20A are electrically connected with the display unit terminals 15 in the display unit 10 via the conductive adhesive layer 92, the rear-surface side electrode pad 53, the via hole, the upper-surface side electrode pad 52, and the conductive adhesive layer 91, sequentially in the stated order.

Accordingly, electric connection that is the same as the one in the first embodiment is provided also between the display unit 10 and the module substrate 20A.

Here, whenwe focus on the relay substrate 50 whose pasting areas 501 have therein the module substrates 20A pasted (hereafter, it will be referred to as a "joined sheet member") , this joined sheet member is an equivalent of a kind of module substrate.

More specifically, eight drive elements 21 are disposed on each joined sheet member, and upper-surface electrode pads 52, which transfer drive signals from the drive elements 21 to the display unit terminals 15, are disposed in a matrix on the upper-surface side. The relay electrode terminals 56a to 58a, which receive electricity and signals form the substrate output terminals 36 to 38, are provided on the edges of each joined sheet member.

### Electricity Supply to the Display Unit 10:

As for the electric connection between the wiring 35 for the display-unit ground and the transparent conductive film 13, in the first embodiment, the substrate output terminals 39 are connected with the transparent conductive film 13 by providing the electrode terminals 29 on the corners of the module substrate at the electricity supplying points P1 to P9. In the present embodiment, by providing electrode terminals 59 (see FIG. 12) for electricity supply on the corners of the joined sheet member (i.e. the corners of the relay substrate 50) so as to extend from the upper surface of the substrate over to the rear surface of the substrate, the electrode terminals 59 are joined with the transparent conductive film 13 via the conductive adhesive layer, and the electrode terminal 59 are joined with the substrate output terminals 39 via conductive elastic members (not shown in FIG. 11, but provided in the same manner in which the conductive elastic members 93 are provided) . With this arrangement the wiring 35 are electrically connected with the transparent conducive film 13.

### Assembly of the Display Apparatus 3

Basically, the display apparatus 3 is assembled in the order of Step 1 through Step 4.

### Step 1: A plurality of module substrates 20A are pasted together side by side in the areas on the relay substrate 50 so as to manufacture the joined sheet member.

More specifically, a conductive adhesive in the form of a paste is screen-printed on the module output terminals 22 provided on the module substrates 20A. Then, the module substrates 20A are pasted while being positioned with the rear-surface side electrode pads 53 provided on the relay substrate 50, and the paste is hardened so as to manufacture the joined sheet member.

### Step 2: It is checked if the manufactured joined sheet member is a good product or not by testing the electrical actions.

More specifically, a probe is provided for the relay electrode terminals 56a to 58a on the relay substrate 50, and a predetermined electric signal is applied so as to examine the outputs from the upper-surface side electrode pads 52. This way, it is tested if the joined sheet member operates properly or not. Only those that had good test results will be used in the following step.

### Step 3: Joined sheet members (good products) are pasted together side by side on the display unit 10.

More Specifically, a conductive adhesive in the form of a paste is screen-printed on the upper-surface side electrode pads 52 provided on the joined sheet members. Then, the joined sheet members are pasted on the rear surface of the display unit 10 while being positioned properly and the paste is hardened.

### Step 4: The main wiring substrate 30 is positioned with and pasted onto what has been manufactured in Step 3. In this pasting step, a conductive elastic member with a conductive adhesive is inserted between the substrate output terminals 36 to 39 and the relay electrode terminals 56a to 58a, and the electrode terminal 59, and hardened. With this arrangement, it is possible to obtain secure connection.

As additional information, in order to strengthen the adhesion and fixation between the module substrate 20A and the main wiring substrate 30, it is acceptable to further adhere these substrates with each other with an adhesive.

Finally, the sealing portion 95 is injected in the periphery areas around the main wiring substrate 30 and the transparent insulative substrate 12 so as to provide hermetical sealing including the module substrate 20A and the organic EL film 14. Thus, the display apparatus 3 is finished.

### Effects achieved by the Assembly Method above

When the display apparatus 3 is actually manufactured, the sizes of the module substrates 20A are considerably small (normally smaller than 1cm square); therefore handling of the substrates is difficult. Further, as the number of module substrates (e. g. hundreds of thousand pieces) to be pasted on the whole display unit increases, it is assumed that the number of pasting processes also increases. Thus, when module substrates are pasted onto the display unit 10 directly, like in the first embodiment, it is assumed that the frequency of errors in the pasting process tends to get high.

Further, the display unit 10 including the organic EL film is fragile; therefore, there is a possibility of damaging the display unit 10 if the module substrates 20A are once pasted thereon and the module substrates with pasting errors need to be replaced.

On the other hand, if joined sheet members are prepared by pasting a plurality of module substrates onto the relay substrates and then these joined sheet members are pasted onto the display unit 10 after they have gone through electric tests, handling of the joined sheet members, as being pasted onto the display unit, is easier because their sizes are larger than those of the module substrates, and also the number of pasting processes becomes smaller. Especially, when a large number of module substrates 20A are pasted together side by side on the relay substrate 50, the number of pasting processes with the display unit 10 becomes considerably smaller.

Thus, according to the manufacturing method of the present embodiment, it is possible to further reduce pasting errors and improve the yield of the manufacturing.

### Example in which a large number of module substrates are pasted onto the relay substrate

The following describes an example in which a large-sized display apparatus is manufactured from a plurality of joined sheet members, each of which is a large-sized relay substrate 50 onto which a large number of module substrates 20A are pasted.

It is assumed that the number of display elements in the display unit 10 (or the size of the display unit 10) as well as the size of the main wiring substrate 30 has been arranged in accordance with the total number of module substrates 20A to be used in the display apparatus.

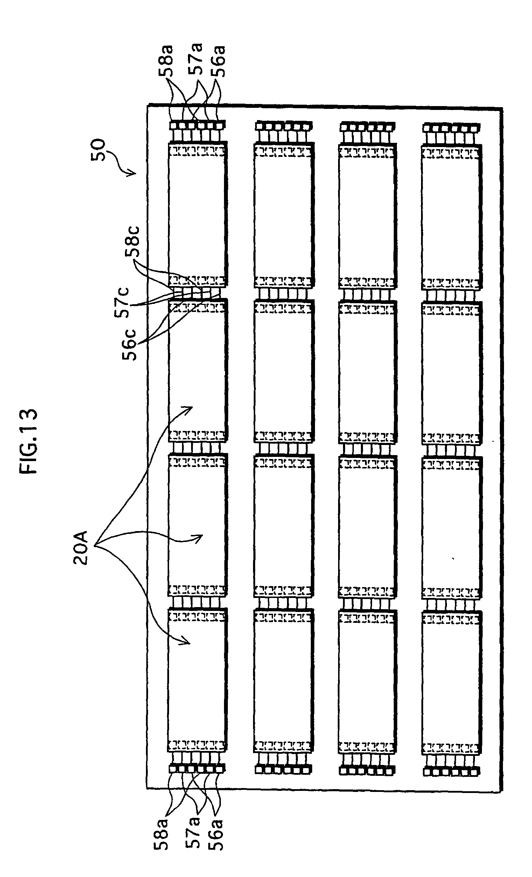

FIG. 13 shows a joined sheet member in which module substrates 20A that are disposed by an arrangement of four by four in the column and row directions are pasted onto the relay substrate 50.

In this joined sheet member, relay electrode terminals 56c to 58c are provided on the relay substrate 50 so as to be placed between two module substrates 20A that are positioned adjacent to each other in the row direction. The module input terminals 26A to 28A, to which the four module substrates 20A disposed in series in the row direction are positioned adj acent, are mutually connected by these relay electrode terminals 56c to 58c. The drive elements 21 on the module substrates 20A are mutually connected by the wirings 24.

With the aforementioned arrangement, on this joined sheet member, all the drive elements 21 disposed in series in the row direction are connected with the relay electrode terminals 56a to 58a via the relay electrode terminals 56c to 58c, the wirings 23, and the wirings 24.

Accordingly, in the display apparatus in which such joined sheet members are used, image display actions are performed in the same manner as explained in the first embodiment.

By manufacturing such joined sheet members that have a large number of module substrates 20A thereon and pasting the joined sheet members onto the rear surface of the display unit 10, and then pasting the main wiring substrate 30 thereto, it is possible to manufacture a large-sized display apparatus with a high yield.

In addition, as a modification example of the joined sheet members, it is also acceptable, for example, to provide, on the rear surfaces of the relay substrates 50, an equivalent of the wirings 24 provided on the upper surfaces of the module substrates 20A, so as to omit the wirings 24 from the module substrates 20A.

### Fourth Embodiment

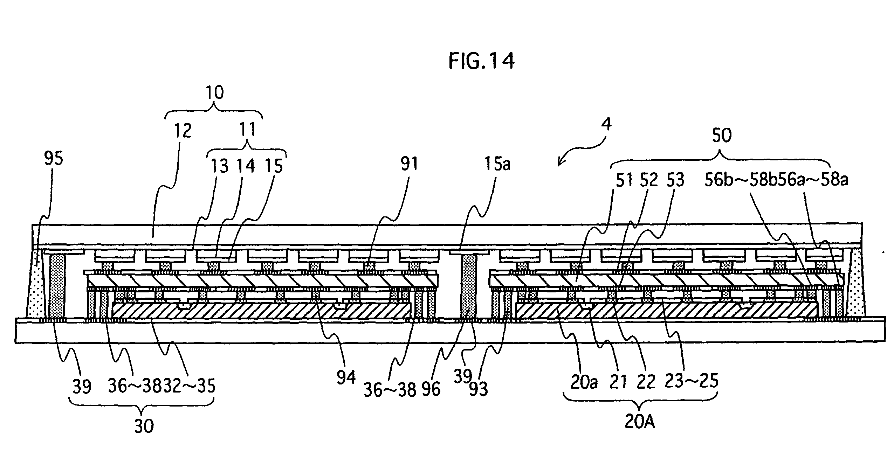

FIG. 14 is a schematic cross-sectional view of the display apparatus 4 of the fourth embodiment.

The display apparatus 4 has the same structure as the display apparatus 3 of the third embodiment. In FIG. 14, the constituent elements that are the same as the ones in FIG. 11 have the same reference characters.

The manner in which the substrate output terminals 39 are connected with the transparent conductive film 13 at the electricity supplying points is different from that of the third embodiment.

More specifically, in the present embodiment, at the electricity supplying points which are selectively provided between the relay substrates 50, electricity supplying space is provided by revoking one display element 11 (one dot). Then, by disposing a conductive elastic member 96 in such an electricity supplying space, the substrate output terminal 39 is connected with the transparent conductive film 13. The following is detailed explanation.

In an area as large as one dot at an electricity supplying point, a display unit terminal for electricity 15a, which is similar to the display unit terminal 15, is provided directly on the transparent conductive film 13, without having an organic EL film 14 provided. Also, electricity supplying space is made available by either making the size of the relay substrate 50 smaller or having a cutout so that the relay substrate 50 does not exist in this area.

The substrate output terminals for the display-unit ground 39 provided on the main wiring substrate 30 are disposed so as to face this electricity supplying space. The display unit terminals for electricity 15a are electrically connected with the substrate output terminals 39 via the conductive elastic members 96.

Such conductive elastic members 96 are substantially the same as the conductive elastic members 93 explained in the third embodiment; however, there is a difference that the conductive elastic member 93 bridges the gap between the relay substrate 50 and the main wiring substrate 30, whereas the conductive elastic member 96 bridges the gap between the display unit 10 and the main wiring substrate 30. Accordingly, as shown in FIG. 14, the conductive elastic members 96 are arranged so that their heights are larger than the conductive elasticmembers 93.

As compared with the display apparatus 3 of the third embodiment, dots are missing at the electricity supplying points in the display apparatus 4 of the present embodiment; however, it is possible to further inhibit power losses, as explained below.

The electrode terminals for electricity supply 59 in the third embodiment are provided on the edges of the relay substrate 50; therefore, it is difficult to make them thick. In the present embodiment, however, it is easy to make the conductive elastic member 96 thicker (i. e. having a larger diameter). Further, since the electricity supplying space as large as one dot is provided, it is possible to make the conductive elastic member 96 sufficiently thick (in the diameter direction).

Accordingly, in the display apparatus 4 of the present embodiment, it is possible to inhibit power losses that may occur during the process of supplying electricity to the display unit 10.

### Assembly of the Display Apparatus 4

The assembly steps are the same as Step 1 through Step 3 explained in the third embodiment, up to the processes of manufacturing the joined sheet members by pasting the module substrates 20A onto the relay substrate 50 and pasting the joined sheet members onto the display unit 10.

In the following Step 4, the main wiring substrate 30 is pasted. In this pasting process, the conductive elastic members 93 with conductive adhesive are inserted between the substrate output terminals 36 to 38 and the relay electrode terminals 56a to 58a. At the same time, the conductive elastic members 96 with conductive adhesive are inserted and hardened also between the display unit terminals for electricity 15a and the substrate output terminals 39.

### Modification Examples

In the present embodiment, like in the third embodiment, the substrate output terminals 36 to 38 provided on the main wiring substrate 30 are connectedwith themodule input terminals 26A to 28A provided on the module substrate 20A via the relay substrate 50; however, it is also acceptable that the module input terminals 26A to 28A are provided, like in the first embodiment, so as to extend from the upper surface side of the sheet-like base member 20a to the rear surface side thereof, so that the module input terminals 26A to 28A are directly connected with the substrate output terminals 36 to 38.

### Fifth Embodiment

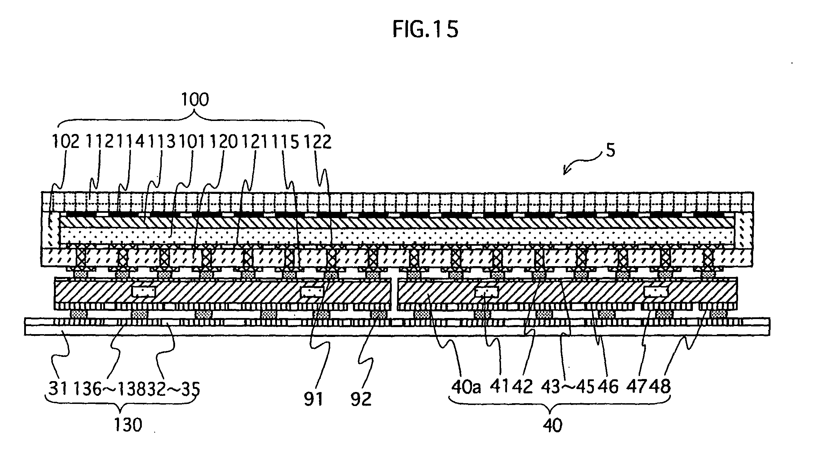

FIG. 15 is a schematic cross-sectional view of the display apparatus 5 of the fifth embodiment.

The display apparatus 5 is a liquid crystal display apparatus. A module substrate 40 and a main wiring substrate 130 that are the same as the ones in the second embodiment are pasted onto the display unit 100, which includes a liquid crystal layer 101 constituting display elements. The number of display elements is determined in accordance with the level of definition of the image display required, like in the case of the EL display apparatus above.

The assembly and the structures of the module substrate 40 and the main wiring substrate 130 are the same as those in the second embodiment. In FIG. 15, the constituent elements that are the same as in FIG. 9 have the same reference characters.

In the display unit 100, the transparent insulative substrate 112 and the opposing substrate 120 are disposed with a predetermined gap therebetween, and the display unit terminals 115 are disposed in a matrix so as to expose on the rear surface of the opposing substrate 120.

On the lower surface of the transparent insulative substrate 112, a color filter 114 that has areas in red, green, and blue and a transparent conductive film 113 that solidly extends all over the color filter 114 are provided.

On the upper surface of the opposing substrate 120, internal electrodes 121 are disposed in a matrix so as to oppose the display unit terminals 115. The internal electrodes 121 are electrically continuous with the display unit terminals 115 by the through electrodes 122 that are provided so as to go through the opposing substrate 120.

The liquid crystal layer 101 is provided between the transparent conductive film 113 and the internal electrodes 121.

The opposing substrate 120 does not need to have transparency; therefore, it is possible to use a substrate that is made of, for example, a ceramic material, a resin material, or a metal material. When a substrate made of a metal material is used, it would be suitable if necessary electrode films are formed after insulating the both surfaces and the through holes by coating them with resin or glass.

In the display unit 100 with the aforementioned arrangement, the display elements are structured with the color filter 114, the transparent conductive film 113, the liquid crystal layer 101, the internal electrodes 121, and the like. By adjusting the drive voltage applied to between the transparent conductive film 113 and the display unit terminal 115, it is possible to adj ust the visible light transmittance at the liquid crystal layer, and thereby to adjust the quantity of visible light reflected by the display elements.

The display unit 100 with such an arrangement can be manufactured by (i) injecting liquid crystal between the transparent insulative substrate 112 on which constituents up to the transparent conductive film 113 are disposed and the opposing substrate 120 on which the internal electrodes 121 are disposed in a matrix and (ii) sealing the periphery areas with a sealing portion 102.

As for the joining of electrode terminals between the substrates in the display apparatus 5, the display unit terminals 115 are joined with the module output terminals 42 via the conductive adhesive layer 91, and the module input terminals 46 to 48 are joined with the substrate output terminals 36 to 38 via the conductive adhesive layer 92.

Further, the electric connection between the transparent conductive layer 113 in the display unit 100 and an external driving device can be made by (i) providing an electricity path that extends from the wiring for the display unit 35 on the main wiring substrate 130 and over to the transparent conductive film 113 via the periphery area of the display unit 100 or (ii) providing a terminal that extends from the rear surface of the display unit 100 over to the transparent conductive film 113 through the opposing substrate 120. Alternatively, it is also acceptable to make connection directly from the outside of the display apparatus 5 to the periphery area of the transparent conductive film 113.

As for the assembly of the display apparatus 5, detailed explanation will be omitted since the display apparatus 5 can be manufactured with the use of the aforementioned display unit 100 on which, in the same manner as in the second embodiment, the module substrates 40 and also the main wiring substrate 130 are attached.

The image display action of the display apparatus 5 is also performed in the same manner as explained in the first embodiment. It should be noted, however, that the light emission periods of the display elements are controlled according to the luminance signals as for the EL display apparatus of the first embodiment, whereas the voltages to be applied to the display elements are controlled by the drive elements 41 according to the luminance signals as for the liquid crystal display apparatus of the present embodiment.

As the drive elements 41 included in the display apparatus 5, it is acceptable to use amorphous polysilicon thin film transistors formed in an array, as an alternative to the IC chips.

The display apparatus 5 with such an arrangement has basically the same effects as explained in the first and second embodiments.

For example, the display unit 100 does not include drive elements such as thin film transistors; therefore, the cost of equipment for manufacturing the display units 100 can be low. In addition, since the structure is simple as a whole, the yield will be high even when display units with large screens are manufactured. Further, the module substrate 40 has the drive elements 41 for driving the display elements of the display unit 100 built in at the inside of the substrate; therefore, the both surfaces of the module substrate 40 are flat, and it is possible to dispose the electrode terminals freely.

As additional information, in the present embodiment the liquid crystal display apparatus 5 includes the module substrates and the main wiring substrate that are the same as the ones in the second embodiment; however, it is also acceptable that the liquid crystal display apparatus includes the module substrates, the main wiring substrate, and the relay substrate having the same arrangements as in the first, third, and fourth embodiments.

### Six Embodiment

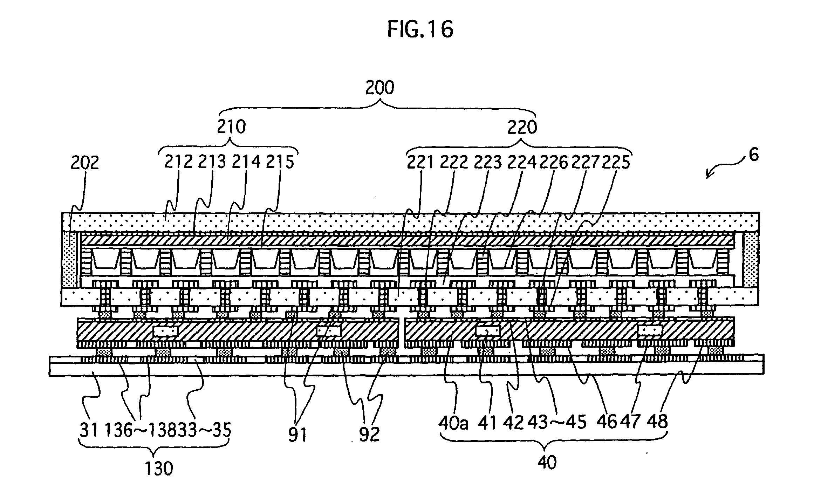

FIG. 16 is a schematic cross-sectional view of the display apparatus 6 of the sixth embodiment.

The display apparatus 6 is a PDP display apparatus. The display apparatus 6 includes a display unit 200 in which light emitting cells (display elements) that emit light in colors caused by plasma discharges are disposed in a matrix, and the module substrates 40 and the main wiring substrate 130, which are the same as the ones in the second embodiment, are pasted onto the display unit 200. The number of display elements is determined, in the same manner as the case of the EL display apparatus above, in accordance with the level of definition of the image display required.

The assembly and the structures of the module substrate 40 and the main wiring substrate 130 are the same as those in the second embodiment. In FIG. 16, the constituent elements that are the same as in FIG. 9 have the same reference characters.

In the display unit 200, the upper plate 210 and the rear plate 220 are disposed with a predetermined gap therebetween. The periphery areas of the plates are sealed by a sealing portion 202, and a predetermined discharge gas is injected into the internal space.

In the upper plate 210,a transparent conductive film 213 is solidly disposed all over the whole rear surface of the transparent insulative substrate 212; a dielectric film 214 and a protective film 215 are disposed so as to cover the transparent conductive film 213.

The rear plate 220 has a structure as described below:

On the upper surface side of the rear surface substrate 221, address electrodes 222, which are separated from each other in the form of dots, are disposed in a matrix, and a lower dielectric film 223 is disposed so as to cover these address electrodes 222. Further, on the lower dielectric layer 223, barrier ribs 224 are provided in stripes, and phosphor layers in colors or red, green, and blue 226 are provided between the barrier ribs 224.

On the rear surface of the rear substrate 221, display unit terminals 225 are disposed in a matrix so as to be positioned in correspondence with the address electrodes 222. The display unit terminals 225 are exposed on the rear surface of the rear substrate 221. The address electrodes 222 are electrically continuous with the display unit terminals 225 by the through electrodes 227 that are provided so as to go through the rear surface substrate 221. These through electrodes 227 can be manufactured with the use of a ceramic multi-layer substrate technique.

As for the joining of the electrode terminals between the substrates in the display apparatus 6, the display unit terminals 225 are joined with the module output terminals 42 via the conductive adhesive layer 91, and the module input terminals 46 to 48 are joined with the substrate output terminals 36 to 38 via the conductive adhesive layer 92.

Further, the electric connection between the transparent conductive layer 213 in the display unit 200 and an external driving device can be made by (i) providing a wiring that extends from the wiring for the display unit 35 provided on the main wiring substrate 130 over to the transparent conductive film 213 via the periphery area of the display unit 200 or (ii) providing a terminal that extends from the rear surface of the display unit 200 over to the transparent conductive film 213 through the rear surface substrate 221. Alternatively, it is also acceptable to make connection directly from the outside of the display apparatus 6 to the periphery area of the transparent conductive film 213.

In the display unit 200 having the aforementioned structure, the display elements are provided on the display unit terminals 225. When predetermined drive voltages with alternating current are applied to between the transparent conductive film 213 and the display unit terminals 225, sustain discharges are generated in spaces between the barrier ribs 224, and thereby visible light is emitted from the phosphor layers 226.

As for the assembly of the display apparatus 6, detailed explanation will be omitted since the display apparatus 6 can be manufactured with the use of the aforementioned display unit 200 on which, in the same manner as in the second embodiment, the module substrates 40 and also the main wiring substrate 130 are attached.

As for the image display action of the display apparatus 6, display elements emit light when predetermined drive voltages with alternating current are applied to between the transparent conductive film 213 and the display unit terminals 225, as mentioned above. In the same manner as explained in the first embodiment, gray-scale image display by the drive elements 41 is achieved by way of controlling the periods during which drive voltages are applied to the display elements according to the luminance signals inputted.

The display apparatus 6 with such an arrangement has basically the same effects as explained in the first and second embodiments.

The display apparatus 6 has advantageous effects that are peculiar to it because it is a PDP display apparatus with a large-sized screen, and is also able to perform a dot-drive on the display elements individually with the use of the drive elements 41.

More specifically, normally a matrix driving method is used in a large-sized PDP display apparatus. In such a case, gray-scale image display is achieved by a method in which the light emission action is repeated within the period of one frame by having a write period and a discharge sustain period that follows; therefore, there is a limitation to the length of the light emission period, and light emission tends to be dispersed. Particularly, in a case of a large-sized screen with a large number of display elements, there is a problem that the write periods are long and the light emission periods are short.

On the contrary, when the drive elements 41 perform a dot-drive on the display elements, as mentioned above, it is possible to achieve gray-scale image display without having write periods; therefore, it is possible to make the light emission from sustain discharges more continuous and also to make the periods of sustain discharges longer as much.

Accordingly, according to the PDP display apparatus of the present embodiment, it is possible to achieve a large-sized display apparatus with high luminance and high image quality.

As additional information, the PDP display apparatus 6 in the present embodiment includes the module substrates and the main wiring substrate that are the same as the ones in the second embodiment; however, it is also acceptable that the PDP display apparatus 6 includes the module substrates, the main wiring substrate, and the relay substrate having the same arrangements as in the first, third, and fourth embodiments.

### Applying the Present Invention to the Matrix Driving Method

In the sixth embodiment above, explanation has been provided on a display apparatus according to the dot-drive method by which the drive elements are able to drive the display elements independently; however, the present invention is not limited to this method and is applicable to a PDP apparatus according to a matrix drive method.

In such a case, display electrodes and address electrodes are disposed in a matrix in the divided areas of the display unit. Also, a matrix driving circuit, which is for applying voltages to the display electrodes and address electrodes for writing and discharge sustaining, is disposed on each module substrate.

In this case also, since it is possible to per form writings in parallel with the use of the driving circuits provided on the module substrates, it is possible to shorten the lengths of the writing periods, compared to the case where the writings are performed sequentially in the whole display apparatus. Thus, it is possible to make the duty ratio higher.

The same is true with organic EL display apparatuses and liquid crystal display apparatuses. In the first through fifth embodiments above, explanation has been provided on an active-type display apparatus; however, the present invention is applicable to display apparatuses according to the matrix driving method such as passive-type EL display apparatuses.

When the present invention is applied to a display apparatus according to the matrix driving method, it is also possible to achieve a large-sized display apparatus having a simple structure.

Further, it is possible to achieve a display apparatus having an even larger screen by disposing a plurality of the display apparatuses explained in the first through six embodiments above, side by side like tiles.

### Industrial Applicability

The display apparatuses of the present invention are applicable for the use as display apparatuses for computers, TVs, and particularly as large-sized and flat display apparatuses.

## Claims

1. A display apparatus comprising:
a display unit including (i) a substrate and (ii) display elements that are disposed on a surface of the substrate so as to be arranged in an array and each of which includes a light display member and a display unit terminal;
a pluralityof module substrates each of which is disposed over a plurality of the display elements;
a main wiring substrate disposed so as to cover the module substrates, wherein
a first wiring for transferring electricity and signals to the module substrates is provided on the main wiring substrate, and
(i) a drive element that supplies a drive signal, (ii) a second wiring for transferring the electricity and the signals transferred via the first wiring to the drive element, and (iii) a module output terminal for transferring the drive signal outputted from the drive element to the display unit terminals are provided on each of the module substrates.

2. The display apparatus of Claim 1, wherein
the module output terminals are positioned on the module substrates so as to oppose the display unit terminals in the display unit.

3. The display apparatus of Claim 1 or Claim 2, wherein
a substrate output terminal being connected to the first wiring is provided on such a surface of the main wiring substrate that opposes the module substrates, and
a module input terminal being connected to the second wiring is provided on each of the module substrates so as to be positioned in correspondence with a position of the substrate output terminal.

4. The display apparatus of Claim 3, wherein
in each of the module substrates, the module input terminal is disposed on an edge of the module substrate so as to extend from one surface thereof over to the other surface thereof.

5. The display apparatus of Claim 3, wherein
in each of the module substrates, the drive element is embedded in the module substrate, and the module input terminal is provided on such a surface of the module substrate that opposes the main wiring substrate.

6. The display apparatus of Claim 5, wherein
the second wiring has a multi-layer wiring structure.

7. The display apparatus of Claim 3, wherein
one or both of (i) connection between the display unit terminals and the module output terminals and (ii) connection between the substrate output terminal and the module input terminal is made by an electrically conductive adhesive.

8. The display apparatus of Claim 1, wherein
a wiring-for-display-unit that supplies electricity to the display unit is provided on the main wiring substrate, and
a connector that connects the wiring-for-display-unit with the display unit is provided either on an edge of one of the module substrates or in a gap between two of the module substrates.

9. The display apparatus of Claim 8, wherein
the connector is an electrically conductive member that is provided on an edge of one of the module substrate so as to extend from one surface thereof over to the other surface thereof.

10. The display apparatus of Claim 1, wherein
in each of the module substrates, the drive element is embedded in such a surface of the module substrate on which the module output terminal is disposed, and
the surface of the drive element is substantially flush with the surface of the module substrate.

11. The display apparatus of Claim 1, wherein
a base material of the module substrates is electrically insulative and is a mixture that includes a thermosetting resin and contains an organic filler within a range of 70 to 95 weight%.

12. The display apparatus of Claim 1, wherein
the drive elements are each either a monocrystal silicon IC or a silicon transistor circuit formed with a thin film.

13. The display apparatus of Claim 1, wherein
the main wiring substrate has a substantially same shape as the substrate that is in the display unit and is transparent and insulative.

14. The display apparatus of Claim 1, wherein
at least one relay substrate is inserted between the display unit and the module substrates, and
the relay substrate has one or more via holes that allow electric connection between the display unit terminals and the module output terminals.

15. The display apparatus of Claim 14, wherein
a pitch with which the module output terminals are arranged in an array on each module substrate is smaller than a pitch with which the display unit terminals are arranged in an array.

16. The display apparatus of Claim 14, wherein
each of the module substrates has an area that is smaller than such an area of the substrate in which display elements driven by the drive element on that module substrate are provided.

17. The display apparatus of any one of Claims 14, 15, and 16, wherein
a wiring-for-display-unit that supplies electricity to the display unit is provided on the main wiring substrate, and
an elastic member having electric conductivity is interposed between the wiring-for-display-unit and the display unit so as to allow electric connection therebetween.

18. The display apparatus of any one of Claims 14, 15, and 16, wherein
a substrate output terminal being connected to the first wiring is provided on such a surface of the main wiring substrate that opposes the module substrates,
a module input terminal beinq connected to the second wiring is provided on each of the module substrates, and
a connecting electrode that allows connection between the substrate output terminal and the module input terminal is provided on the relay substrate.

19. The display apparatus of Claim 18, wherein
the connecting electrode on the relay substrate is electrically connected with the substrate output terminal on the main wiring substrate by an elastic member having electric conductivity.

20. The display apparatus of Claim 14, wherein
the module substrates are disposed on the relay substrate.

21. The display apparatus of Claim 20, wherein
a relay electrode terminal that electrically connects the module substrates on the relay substrate with one another is provided on the relay substrate.

22. The display apparatus of Claim 14, wherein
a base material of the relay substrate is an electrically insulative material in which an organic filler is mixed with a thermosetting resin and the organic filler is contained within a range of 70 to 95 weight%.

23. The display apparatus of Claim 1, wherein
the substrate in the display unit is transparent and insulative,
the light display member is made up of at least a transparent conductive film disposed on the substrate in the display unit and an organic electroluminescence film disposed on the transparent conductive film, and
the display unit terminals are disposed on the organic electroluminescence film so as to be arranged in an array, being separate from each other.

24. The display apparatus of Claim 23, wherein
a peripheral area at which the substrate in the display unit opposes the main wiring substrate is hermetically sealed with a sealing member.

25. The display apparatus of Claim 1, wherein
the display unit is a liquid crystal panel, and
the light display member includes a transparent conductive layer on which a liquid crystal layer and an opposing electrode being connected with the display unit terminal are provided.

26. The display apparatus of Claim 1, wherein
the substrate in the display unit is transparent and insulative,
the display unit is a gas discharge panel, and
the light display member includes (i) a conductive layer provided on the substrate in the display unit and (ii) an address electrode that is disposed so as to oppose the conductive layer with a discharge space being interposed therebetween and is connected to the display unit terminal.

27. A manufacturing method of a display apparatus, comprising:
a display unit manufacturing step of manufacturing a display unit that has, on a surface of a substrate, display elements that (i) each include a light display member, (ii) are arranged in an array, and (iii) with each of which a display unit terminal is provided;
a module substrate manufacturing step of manufacturing module substrates that each have (i) a drive element which supplies a drive signal, (ii) a second wiring for transferring electricity and signals to the drive element, (iii) a module output terminal for transferring the drive signal outputted from the drive element to the display unit terminals;
a main wiring substrate manufacturing step of manufacturing a main wiring substrate on which a first wiring for transferring electricity and signals to the module substrates is provided;
a first pasting step of pasting the display unit manufactured in the display unit manufacturing step with the module substrates manufactured in the module substrate manufacturing step; and
a second pasting step of pasting the main wiring substrate manufactured in the main wiring substrate manufacturing step onto a joined member, which is an outcome of the first pasting step.

28. The manufacturing method of a display apparatus of Claim 27, further comprising, prior to the first pasting step, a relay substrate manufacturing step of manufacturing a relay substrate that has one or more via holes which allow electric connection between the display unit terminals and the module output terminals, and
the first pasting step includes:
a first substep of pasting the module substrates manufactured in the module substrate manufacturing step and the relay substrate manufactured in the relay substrate manufacturing step; and
a second substep of pasting the display unit manufactured in the display unit manufacturing step and a joined member, which is an outcome of the first substep.
